(19) Europäisches Patentamt
European Patent Office
Office européen des brevets

(11) **EP 4 586 772 A1**

(12) **EUROPEAN PATENT APPLICATION**

(43) Date of publication:
**16.07.2025 Bulletin 2025/29**

(21) Application number: **25150623.4**

(22) Date of filing: **08.01.2025**

(51) International Patent Classification (IPC):
**H10H 29/14** (2025.01)   **H10H 29/851** (2025.01)
**H10H 29/85** (2025.01)

(52) Cooperative Patent Classification (CPC):
**H10H 29/142; H10H 29/8513; H10H 29/8517**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.01.2024 US 202463619390 P
30.08.2024 US 202463689007 P
30.12.2024 US 202419005826**

(71) Applicant: **Seoul Semiconductor Co., Ltd.
Ansan-si, Gyeonggi-do 15429 (KR)**

(72) Inventors:
• **JANG, Borami
15429 Ansan-si (KR)**
• **SHIN, Dongsun
15429 Ansan-si (KR)**

(74) Representative: **Stolmár & Partner
Patentanwälte PartG mbB
Blumenstraße 17
80331 München (DE)**

(54) **LIGHT EMITTING APPARATUS**

(57)     A light emitting apparatus includes a substrate and at least one light emitting device disposed on the substrate and configured to emit light, wherein a luminous flux in a blue wavelength region is in the range of 0.01 times to 0.1 times the total luminous flux.

【FIG. 13A】

**Description**

[Technical Field]

The disclosed technology relates to a light emitting apparatus, and more particularly to a light emitting apparatus for displays including light emitting diodes.

[Background Art]

Recently, nitride semiconductors have been widely used as a base material for light emitting devices, such as light emitting diodes. Since nitride semiconductors can have various energy bandgaps depending on the composition ratio of Group III elements, light can be realized in various wavelength bands by controlling the composition ratio of elements, such as Al, Ga, In, or others.
For an active layer, a multi-quantum well structure (MQW) may be used and an emission wavelength of a light emitting device may be determined according to the composition ratio of nitride semiconductors in well layers of the multi-quantum well structure.
Light is composed of a mixture of three primary colors of red, green, and blue, and various colors can be realized by combining the three primary colors of RGB.
There is a need for development of technology capable of ensuring that clearer colors can be displayed with further improved color reproduction in display apparatuses adopting combinations of red (R), green (G), and blue (B) light.

[Disclosure]

[Technical Problem]

It is an object of the disclosed technology to provide a light emitting apparatus for displays capable of improving color brightness and color reproduction.

[Technical Solution]

In accordance with one embodiment of the disclosed technology, a light emitting apparatus (100) includes: a substrate (10); and at least one light emitting device (20) disposed on the substrate (10) and configured to emit light.
In one embodiment, a luminous flux in a blue wavelength region may be in the range of 0.01 times to 0.1 times the total luminous flux.
In one embodiment, a luminous flux in a green wavelength region may be in the range of 0.7 times to 0.89 times the total luminous flux.
In one embodiment, a luminous flux in a red wavelength region may be in the range of 0.15 times to 0.3 times the total luminous flux.
In one embodiment, light emitted from the light emitting device (20) may have a peak wavelength with a first radiant intensity in the blue wavelength region and a peak wavelength with a second radiant intensity in the green wavelength region, which is less than the first radiant intensity, wherein the first radiant intensity may be greater than or equal to 4 times the second radiant intensity.
In one embodiment, a first radiant flux in the blue wavelength region may be in the range of 30% to 50% of the total radiant flux, a second radiant flux in the green wavelength region may be in the range of 30% to 40% of the total radiant flux, and a third radiant flux in the red wavelength region may be in the range of 10% to 30% of the total radiant flux.
In one embodiment, the light emitting apparatus (100) may have a color reproduction rate of 85% or more.
In one embodiment, the light emitting apparatus (100) may have a gamut ratio of 85% or more.
In one embodiment, the light emitting apparatus (100) may further include a color filter (150) through which light emitted from the light emitting device (20) passes, and the light may have red color coordinates (Xr, Yr) shifted to a shorter wavelength side, and green color coordinates (Xg, Yg) and blue color coordinates (Xb, Yb) shifted to a longer wavelength side, after passing through the color filter (150).

[Effects of the Invention]

The disclosed technology can provide a light emitting apparatus for displays capable of improving color brightness and color reproduction.

[Description of Drawings]

FIG. 1A and FIG. 1B are cross-sectional views of light emitting apparatuses according to embodiments of the disclosed technology.

FIG. 2 is a partially enlarged plan view of the light emitting apparatuses shown in FIG. 1A and FIG. 1B.

FIG. 3 is a cross-sectional view of a light emitting device according to a first embodiment.

FIG. 4 is a cross-sectional view of a light emitting device according to a second embodiment.

FIG. 5 is a cross-sectional view of a light emitting device according to a third embodiment.

FIG. 6 is a cross-sectional view of a light emitting device according to a fourth embodiment.

FIG. 7 is a cross-sectional view of a light emitting device according to a fifth embodiment.

FIG. 8 is a graph depicting a relative radiant intensity spectrum of light emitted from a light emitting device according to an embodiment of the disclosed technology.

FIG. 9 is a graph depicting a relative radiant flux spectrum of the emitted light of FIG. 8 and a spectral luminous efficacy curve.

FIG. 10 is a graph depicting a relative luminous intensity spectrum of the emitted light according to the spectral luminous efficacy curve.

FIG. 11 is a graph depicting a filter transmittance of a color filter in the light emitting apparatuses shown in FIG. 1A and FIG. 1B.

FIG. 12 is a graph depicting a relative radiant intensity spectrum of light having passed through the color filter shown in FIG. 11.

FIG. 13A is a graph depicting a relative luminous intensity spectrum of the light having passed through the color filter according to the spectral luminous efficacy curve.

FIG. 13B is a graph depicting an example of a luminous intensity spectrum in each wavelength region of light having passed through the color filter.

FIG. 14A is a graph illustrating CIE color coordinate spaces of the light emitting apparatuses according to the first to fifth embodiments.

FIG. 14B is a graph depicting a color gamut of the light having passed through the color filter of FIG. 11.

FIG. 14C is a graph depicting variation of the color gamut of the light having passed through the color filter of FIG. 11.

FIG. 15A to FIG. 15G are graphs depicting relative radiant intensity spectra of light emitted from light emitting devices according to the first through fifth embodiments.

FIG. 16A to FIG. 16E are graphs depicting relative luminous intensity spectra according to a spectral luminous efficacy curve of the light emitted from the light emitting devices according to the first through fifth embodiments.

FIG. 17A to FIG. 17E are graphs depicting relative luminous intensity spectra according to a spectral luminous efficacy curve of light emitted from the light emitting devices according to the first to fifth embodiments and having passed through a color filter.

[Detailed Description]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

The disclosed technology provides a light emitting apparatus 100 including a substrate 10 and at least one light emitting device 20 disposed on the substrate 10 and configured to emit light. Hereinafter, exemplary embodiments of the disclosed technology will be described in more detail with reference to the accompanying drawings.

The light emitting apparatus 100 may be a light emitting apparatus for displays, such as a display panel applied to a TV or a monitor of a desktop, laptop, or others.

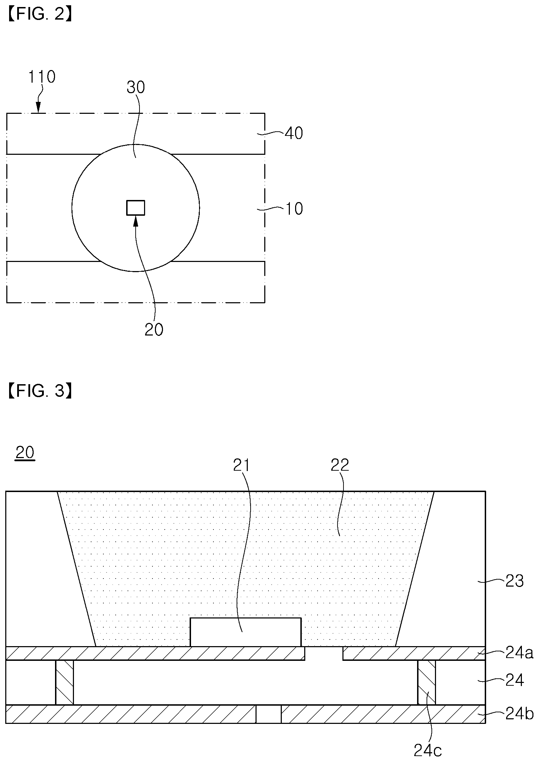

For example, as shown in FIG. 2, the light emitting apparatus 100 may be an LCD panel including a plurality of light emitting devices 20.

The light emitting apparatus 100 may include a backlight unit (BLU) 110 on which the plurality of light emitting devices 20 is disposed, and a color filter 150 disposed on the backlight unit (BLU) 110.

The light emitting apparatus 100 may further include a first polarizing plate 120 disposed on the backlight unit 110, a TFT layer 130 disposed on the first polarizing plate 120 and including an electronic circuit layer, a liquid crystal layer 140 disposed between the TFT layer 130 and the color filter 150 and having light transmission controlled in each cell by the TFT layer 130, and a second polarizing plate 160 disposed on the color filter 150.

The backlight unit 110 may include a substrate 10 and a plurality of light emitting devices 20 disposed on the substrate 10.

As a light source, the plurality of light emitting devices 20 may be uniformly disposed on a surface of the substrate 10 or may be disposed at a side of the substrate 10.

The substrate 10 may be realized in various structures depending on the type of backlight unit 110, for example, a PCB strap on which the plurality of light emitting devices 20 is mounted to be spaced apart from each other in a row, as shown in FIG. 2, or a plurality of PCB straps mounted on a backlight panel 40 and spaced apart from each other in a first direction, without being limited thereto.

Here, the backlight unit 110 may further include a lens 30 that covers a light exit surface of the light emitting device 20 mounted on the substrate 10 to control light diffusion and light path.

The backlight unit 110 may further include a diffusion sheet for light diffusion, a prismatic sheet for improving luminous efficacy, and the like.

The first polarizing plate 120 may be disposed on the backlight unit 110 and may change light from the backlight unit 110 into a first directional polarized state.

The TFT layer 130 is disposed on the first polarizing plate 120 and may be realized in various configurations including an electronic circuit layer to enable control of the liquid crystal layer 140. The TFT layer 130 may be formed on a glass substrate.

The liquid crystal layer 140 is a layer in which light transmission is controlled in each cell by the TFT layer 130, and may include a plurality of cells having properties of maintaining or changing the direction of light depending on voltage applied thereto.

The color filter 150 is a layer disposed on the liquid crystal layer 140 and configured to allow RGB colors to appear, in which a subpixel R emitting red light, a subpixel G emitting green light, and a subpixel B emitting blue light may form a single RGB pixel. The color filter 150 may be formed on a glass substrate.

The second polarizing plate 160 is a polarizing layer disposed on the color filter 150 and may be configured to block light having passed through the liquid crystal layer 140 and the color filter 150 or to allow light to pass through the second polarizing plate 160 and to be emitted outside the light emitting apparatus 100.

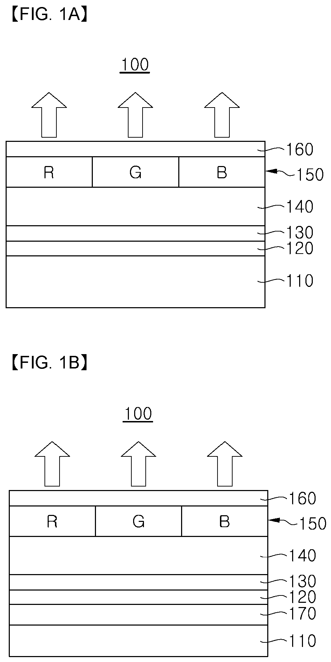

Unlike the light emitting apparatus shown in FIG. 1A, the light emitting apparatus 100 may be a display panel utilizing a quantum dot film (QD film) 170, as shown in FIG. 1B.

The light emitting apparatus 100 according to the embodiment of FIG. 1B may include a backlight unit (BLU) 110 on which a plurality of light emitting devices 20 is disposed, a QD film 170 disposed on the backlight unit 110, and a color filter 150 disposed on the QD film 170.

The light emitting apparatus 100 may further include a first polarizing plate 120 disposed on the QD film 170, a TFT layer 130 disposed on the first polarizing plate 120 and including an electronic circuit layer, a liquid crystal layer 140 disposed between the TFT layer 130 and the color filter 150, in which light transmission is controlled in each cell by the TFT layer 130, and a second polarizing plate 160 disposed on the color filter 150.

In FIG. 1B, each of the light emitting devices 20 may include a blue light emitting diode configured to emit blue light.

In this embodiment, the QD film 170 is a film including nanoscale inorganic semiconductor particles having a size of 2 nm to 10 nm and may exhibit different colors depending on the size thereof. For example, while passing through the QD film 170, blue light emitted from the light emitting devices 20 may become green light and red light, which in turn are mixed with the blue light emitted from the light emitting devices to generate white light.

As shown in FIG. 3, the light emitting device 20 of the light emitting apparatus 100 according to the disclosed technology may be a light source including at least one light emitting diode 21 and may include a plurality of light emitting diodes 21.

The light emitting diode 21 is a light emitting diode chip disposed on a surface of a circuit board 24 and configured to generate light and may be realized in various configurations. The circuit board 24 includes an insulating layer and interconnections for electrical connection to the light emitting diodes 21 and may include circuitry for power supply to the light emitting diodes 21 and driving thereof.

Further, the circuit board 24 may be formed in a multilayer structure and may be formed to various thicknesses, as needed.

Specifically, the circuit board 24 may include an upper interconnection 24a formed on an upper surface thereof and electrically connected to electrodes of the light emitting diode 21, a lower interconnection 24b formed on a lower surface thereof, and a through-interconnection 24c electrically connecting the upper interconnection 24a to the lower interconnection 24b. The light emitting diodes 21 may be mounted on the upper surface of the circuit board 24 in various ways including wiring, bonding, soldering, and the like.

The light emitting diode 21 may include semiconductor layers formed on a growth substrate.

The growth substrate may be selected from any substrates that allow growth of nitride semiconductors thereon and may include, for example, a heterogeneous substrate, such as a sapphire substrate, a silicon substrate, a silicon carbide substrate, or a spinel substrate, and may also include a homogeneous substrate, such as a gallium nitride substrate, an aluminum nitride substrate, or others.

The light emitting diode 21 may include a first conductivity type semiconductor layer, an active layer, and a second conductivity type semiconductor layer.

The first conductivity type semiconductor layer may be a semiconductor layer grown on a surface of the growth substrate and a buffer layer may be further formed between the first conductivity type semiconductor layer and the growth substrate. The buffer layer may include a nitride semiconductor, such as GaN, and may be grown by metal organic chemical vapor deposition (MOCVD). The buffer layer can improve crystallinity of the semiconductor layers grown on the growth substrate in a subsequent process and can also serve as a seed layer for growth of nitride semiconductor layers on a heterogeneous substrate.

The first conductivity type semiconductor layer may include a nitride semiconductor, such as (Al, Ga, In)N, and may be grown on the growth substrate through a technique, such as MOCVD, MBE, HVPE, or others. In addition, the first conductivity type semiconductor layer may be doped with at least one type of n-type dopant, such as Si, C, Ge, Sn, Te, Pb, or others. However, it should be understood that the disclosed technology is not limited thereto. Alternatively, the first conductivity type semiconductor layer may also be doped with a p-type dopant to become an opposite conductivity type.

The active layer is a light emitting layer formed on the first conductivity type semiconductor layer and may have a multi-quantum well structure (MQW).

The active layer may include a nitride semiconductor, such as (Al, Ga, In)N, and may be grown on the first conductivity type semiconductor layer through a technique, such as MOCVD, MBE, HVPE, or others.

The active layer may include a quantum well structure (QW) including at least two barrier layers and at least one well layer. Alternatively, the active layer may include a multi-quantum well structure (MQW) including a plurality of barrier layers and a plurality of well layers.

The wavelength of light emitted from the active layer may be adjusted by controlling the composition ratio of the nitride semiconductor layer of the well layer. Here, the well layer may include a nitride semiconductor containing indium (In).

The well layer is disposed between the barrier layers and the bandgap energy of the well layer is smaller than that of the barrier layer.

The well layer may include or be formed of $In_xGa_{(1-x)}N$ (0<x< 1), in which the composition ratio (x) of In may be controlled according to the wavelength of light emitted from the active layer.

The barrier layers and the well layers are alternately stacked one above another, preferably alternately stacked at least twice. A barrier layer and a well layer adjacent thereto may constitute a pair

The second conductivity type semiconductor layer may be a semiconductor layer formed on the active layer.

The second conductivity type semiconductor layer may include a nitride semiconductor, such as (Al, Ga, In)N, and may be grown through a technique such as MOCVD, MBE, HVPE, or others.

The second conductivity type semiconductor layer may be doped to become a conductivity type opposite to the conductivity type of the first conductivity type semiconductor layer. For example, the second conductivity type semiconductor layer may be doped with p-type dopants, such as Mg.

The second conductivity type semiconductor layer may have a monolayer structure having a composition, such as p-GaN, and may further include an AlGaN layer therein, without being limited thereto.

The light emitting diode 21 may further include an insulating layer covering the first conductivity type semiconductor layer and the second conductivity type semiconductor layer and defining openings in which two electrode pads are disposed. The two electrode pads may be electrically connected to the first conductivity type semiconductor layer and the second conductivity type semiconductor layer, respectively, through the openings in the insulating layer. However, it should be understood that the structure of the light emitting diode 21 according to the disclosed technology is not limited thereto and may be implemented in various structures.

It will be apparent that the light emitting diode 21 may be modified into various structures including a flip-chip structure, a vertical structure, a lateral structure, or others. The growth substrate may be omitted depending on the shape of the light emitting diode 21. It should be understood that the plurality of light emitting diodes 21 may be vertically stacked to form a single light emitting unit.

The light emitting diode 21 may emit blue light B and may be a blue light emitting diode having a central wavelength in the blue wavelength region.

The blue wavelength region may range from 400 nm to 480 nm, and the light emitted by the light emitting diode 21 may have a peak wavelength between 440 nm and 457.5 nm or between 457.5 nm and 470 nm.

In addition, light emitted from the blue light emitting diode 21 may have a difference of 2 nm and 15 nm between a peak wavelength and a dominant wavelength. Specifically, the blue light emitting diode 21 may have a peak wavelength between 455 nm and 475 nm and a dominant wavelength between 460 nm and 480 nm. The peak wavelength of the blue light emitting diode may be a shorter wavelength than the dominant wavelength thereof.

Alternatively, the light emitting diode 21 may emit green light G and may be a green light emitting diode having a peak wavelength in the green wavelength region.

The green wavelength region may range from 480 nm to 590 nm, and the light emitted by the light emitting diode 21 may have a peak wavelength between 530 nm and 545 nm, preferably between 535 nm and 540 nm.

Further, light emitted from the green light emitting diode 21 may have a difference of 5 nm and 20 nm between a peak wavelength and a dominant wavelength. Specifically, the green light emitting diode 21 may have a peak wavelength between 520 nm and 540 nm and a dominant wavelength between 525 nm and 545 nm. The peak wavelength of the green light emitting diode 21 may be a shorter wavelength than the dominant wavelength thereof.

Alternatively, the light emitting diode 21 may emit red light R and may be a red light emitting diode having a central wavelength in the red wavelength region.

The red wavelength region may range from 590 nm to 750 nm, and the light emitted by the light emitting diode 21 may have a peak wavelength between 615 nm and 645 nm, preferably between 620 nm and 640 nm.

In addition, light emitted from the red light emitting diode 21 may have a difference of 5 nm and 20 nm between a peak wavelength and a dominant wavelength. Specifically, the red light emitting diode 21 may have a peak wavelength between 620 nm and 640 nm and a dominant wavelength between 610 nm and 630 nm. The peak wavelength of the red light emitting diode 21 may be a longer wavelength than the dominant wavelength thereof.

Alternatively, the light emitting diode 21 may be a light emitting diode chip having a peak wavelength in at least two of the blue wavelength region, the green wavelength region, or the red wavelength region. For example, the light emitting diode 21 may emit light having peak wavelengths in all of the blue wavelength region, the green wavelength region, and the red wavelength region, respectively. Or the light emitting diode 21 may emit light having peak wavelengths in both the blue wavelength region and the green wavelength region, respectively. Application of the light emitting diode 21 having a plurality of peak wavelengths can improve color purity.

When the light emitting diode 21 emits light having peak wavelengths in all of the blue wavelength region, the green wavelength region, and the red wavelength region, the light emitting device 20 may emit white light generated by mixing blue, green, and red.

The light emitting device 10 may further include a sidewall 23 surrounding the light emitting diode 21. A cavity in which one or more light emitting diode 21 are seated may be formed by the sidewall 23.

The sidewall 23 may form an inclined surface to constitute a reflective surface that reflects light emitted from the light emitting diode 21 in a lateral direction toward an upper side of the light emitting device 10.

Although the sidewall 23 is spaced apart from side surfaces of the light emitting diode 21 in FIG. 3. It should be understood that the sidewall 23 may adjoin the side surfaces of the light emitting diode 21.

The light emitting device 20 may include a plurality of light emitting diodes 21, in which case the peak wavelengths of light emitted from the light emitting diodes 21 may be the same or different from each other.

For example, FIG. 3 shows a light emitting device 20 according to a first embodiment of the disclosed technology, which may include a light emitting diode 21 and a wavelength converter 22 configured to convert the wavelength of light emitted from the light emitting diode 21. The spectrum of light emitted from the light emitting diode 21 and the spectrum of light emitted having passed through the wavelength converter 22 may have one or more different peak wavelengths.

The light emitting diode 21 may be a blue light emitting diode configured to emit blue light B and the wavelength converter 22 may include a yellow wavelength conversion material that generates yellow light or a green wavelength conversion material that generates green light. The yellow or green wavelength conversion material may include fine phosphor particles, quantum dots, or organic dyes. The fine phosphor particles generating green or yellow light may include at least one of LuAG series, YAG series, beta-SiAlON series, nitride series, silicate series, halophosphide series, or oxynitride series phosphor particles, without being limited thereto. The light emitting device may have a mixture of blue light emitted from the light emitting diode 21 and yellow or green light generated in the wavelength converter 22. At this time, the light emitted from the light emitting apparatus 100 can represent a wider color gamut when the light passes through the color filter.

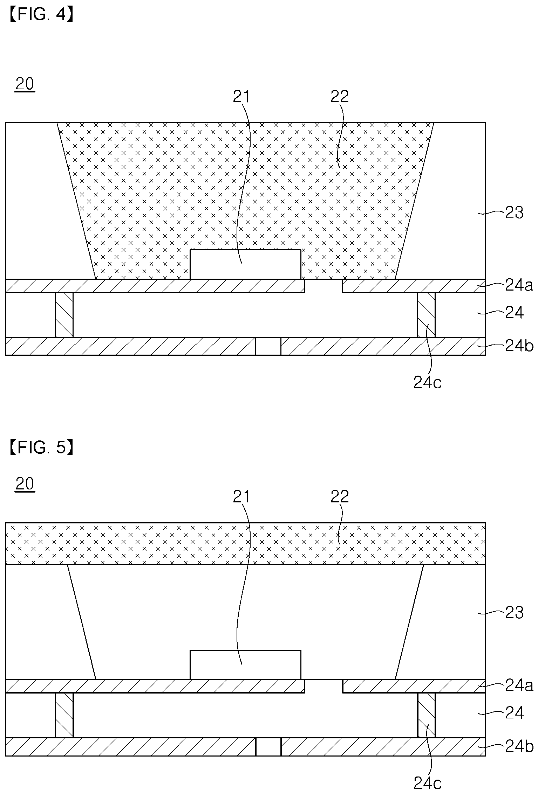

As another example, FIG. 4 shows a light emitting device 20 according to a second embodiment of the disclosed technology, in which the light emitting device 20 may include a light emitting diode 21 and a wavelength converter 22 that converts the wavelength of light emitted from the light emitting diode 21.

Here, the light emitting diode 21 may be a blue light emitting diode configured to emit blue light B. In addition, the wavelength converter 22 may include at least one of a yellow wavelength conversion material that generates yellow light or a green wavelength conversion material that generates green light, and a red wavelength conversion material that generates red light. Through this, the light emitted from the wavelength converter 22 may have peak wavelengths in the blue, yellow or green, and red wavelength regions, respectively. Through this, the light emitting apparatus 100 can represent a wider red color gamut when the light passes through the color filter 150.

The yellow or green wavelength conversion material may include fine phosphor particles, quantum dots, or organic dyes. The phosphor particles generating green or yellow light may include at least one of LuAG series, YAG series, beta-SiAlON series, nitride series, silicate series, halophosphide series, or oxynitride series phosphor particles.

The red wavelength conversion material may have various configurations so long as the red wavelength conversion material can be excited by light emitted from the light emitting diode 21 to generate light in the red wavelength region. For example, the red wavelength conversion material may include nitride phosphors, such as CaAlSiN, SrCaSiN, and SrSiN, aluminate phosphors, such as $(Sr,Ba)Al_2O_4$, fluoride compounds, such as $KSF(K_2SiF_6:Mn)$, or quantum dots (QDs) generating red light. In addition, the yellow wavelength conversion material may include yellow phosphors, such as YaG, TaG, or orthosilicate. The light emitting device may emit mixed light of blue light emitted from the light emitting diode 21 and yellow, green, and red light emitted from the wavelength converter 22.

As another example, FIG. 5 shows a light emitting device 20 according to a third embodiment of the disclosed technology, in which the light emitting device 20 may include a light emitting diode 21 and a wavelength converter 22 that converts the wavelength of light emitted from the light emitting diode 21. In this embodiment, the wavelength converter 22 may be realized in the form of a film and in the form of a thin film that has a thickness of 20% or less of the entire thickness of the light emitting device 20. When the wavelength converter 22 is realized in the form of a film, the light emitting device can improve luminous efficacy by reducing reabsorption of the emitted light by the wavelength converter 22.

Here, the light emitting diode 21 may be a blue light emitting diode configured to emit blue light B and the wavelength converter 22 may include a quantum dot (QD) phosphor. The wavelength converter 22 may include QD particles that generate green light, QD particles that generate yellow light, and QD particles that generate red light. In addition, the wavelength converter 22 may include an organic dye and fine phosphor particles. The phosphor particles generating green or yellow light may include at least one of LuAG series, YAG series, beta-SiAlON series, nitride series, silicate series, halophosphide series, or oxynitride series phosphor particles; and the red phosphor particles may include nitride phosphors, such as CaAlSiN, SrCaSiN, and SrSiN, aluminate phosphors, such as $(Sr,Ba)Al_2O_4$, or fluoride compounds, such as $KSF(K_2SiF_6:Mn)$. The light emitting device may emit mixed light of blue light emitted from the light emitting diode 21 and yellow, green, and red light generated by the wavelength converter 22, whereby the light emitting apparatus 100 can represent a wider color gamut when the light passes through the color filter 150. Furthermore, the light emitting diode 21 may be a light emitting diode configured to emit mixed light and may have a plurality of peaks in the blue and green or red regions. Here, the wavelength converter 22 may be excited by light mainly composed of blue light to emit light having a different peak wavelength. For example, the light emitting diode may have peak wavelengths in the blue and green wavelength regions and the wavelength converter 22 may excite a fraction of light in the blue wavelength region to emit light having a peak wavelength in the red wavelength region. As such, the light emitting diode 21 may have a plurality of different peak wavelengths and the light emitting apparatus 100 can represent a wider color gamut when the light passes through the color filter 150.

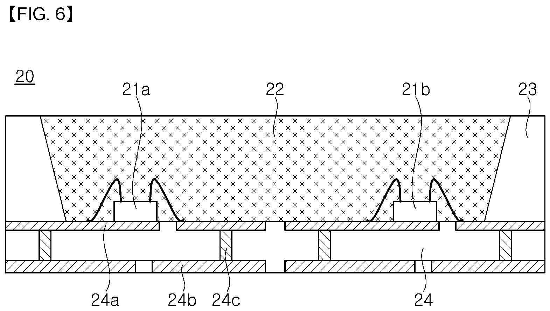

As another example, FIG. 6 shows a light emitting device 20 according to a fourth embodiment of the disclosed technology, in which, unlike the first to third embodiments, the light emitting device 20 may include a plurality of light emitting diodes 21, for example, a first light emitting diode 21a and a second light emitting diode 21b.

Among the plurality of light emitting diodes 21, the first light emitting diode 21a and the second light emitting diode 21b may have different peak wavelengths. The first light emitting diode 21a may have a shorter peak wavelength than the second light emitting diode 21b. Through this, the range of the color gamut that can be represented by the light emitting device 100 may be expanded.

At least one of the light emitting diodes 21 may be a blue light emitting diode configured to emit blue light and at least one of the remaining light emitting diodes 21 may be a green light emitting diode configured to emit green light. Through this, the range of the blue-green color gamut that can be represented by the light emitting device 100 may be expanded. Alternatively, at least one of the light emitting diodes 21 may be a blue light emitting diode configured to emit blue light and at least one of the remaining light emitting diodes 21 may be a red light emitting diode configured to emit red light. Through this, the range of the blue-red color gamut that can be represented by the light emitting device 100 may be expanded.

For example, referring to FIG. 6, the first light emitting diode 21a may be a blue light emitting diode and the second light emitting diode 21b may be a green light emitting diode. Alternatively, the first light emitting diode 21a may be a blue light emitting diode and the second light emitting diode 21b may be a red light emitting diode. Each of the first light emitting diode 21a and the second light emitting diode 21b may be provided in plural and the number of first light emitting diodes 21a may be different from the number of second light emitting diodes 21b. Through this, the insufficient light intensity can be compensated, improving light uniformity.

When the first light emitting diode 21a is a blue light emitting diode and the second light emitting diode 21b is a green light emitting diode, the wavelength converter 22 may include a red wavelength conversion material. The light emitting device may emit mixed light of blue light emitted from the light emitting diode 21 and green light and red light generated by the wavelength converter 22. Here, each of the first light emitting diode 21a configured to emit blue light and the second light emitting diode 21b configured to emit green light may be provided in plural. It will be apparent that the first light emitting diode 21a configured to emit blue light and the second light emitting diode 21b configured to emit green light may be provided in various combinations, for example, two first light emitting diodes 21a and two second light emitting diode 21b (total of four light emitting diodes), two first light emitting diodes 21a and a single second light emitting diode 21b (total of three light emitting diodes), and the like. Through this, the insufficient light intensity can be compensated, improving light uniformity.

Alternatively, when the first light emitting diode 21a is a blue light emitting diode and the second light emitting diode 21b is a red light emitting diode, the wavelength converter 22 may include a green wavelength conversion material. The light emitting device may emit mixed light of blue light and red light emitted from the light emitting diode 21 and green light generated by the wavelength converter 22. Here, each of the first light emitting diode 21a configured to emit blue light and the second light emitting diode 21b configured to emit red light may be provided in plural. It will be apparent that the first light emitting diode 21a configured to emit blue light and the second light emitting diode 21b configured to emit red light may be provided in various combinations, for example, two first light emitting diodes 21a and two second light emitting diode 21b (total of four light emitting diodes), two first light emitting diodes 21a and a single second light emitting diode 21b (total of three light emitting diodes), and the like. Through this, the insufficient light intensity can be compensated, improving light uniformity.

The light excited by the wavelength converter 22 may have a longer peak wavelength than the light emitted from the first light emitting diode 21a and the second light emitting diode 21b. In addition, the wavelength converter 22 may convert a greater quantity of light having shorter wavelengths among the light emitted from the first light emitting diode 21a and the second light emitting diode 21b.

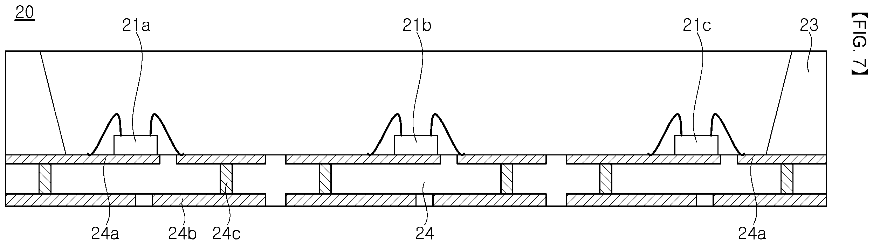

As another example, FIG. 7 shows a light emitting device 20 according to a fifth embodiment of the disclosed technology, in which, unlike the first to third embodiments, the light emitting device 20 may include a plurality of light emitting diodes 21, for example, first to third light emitting diodes 21a to 21c.

The plurality of light emitting diodes 21 may have different peak wavelengths. At least one of the light emitting diodes 21 may emit blue light, at least one of the remaining light emitting diodes 21 may emit green light, and at least one of the remaining light emitting diodes 21 may emit red light. The light emitting device may realize different colors by combining light having peak wavelengths in different wavelength regions.

At least one of the light emitting diodes 21 may be a blue light emitting diode configured to emit blue light, at least one of the remaining light emitting diodes 21 may be a green light emitting diode configured to emit green light, and at least one of the remaining light emitting diodes 21 may be a red light emitting diode configured to emit red light. Through this, clear blue, green, and red representation may be possible from the light emitting device 100.

For example, the first light emitting diode 21a may be a blue light emitting diode, the second light emitting diode 21b may be a green light emitting diode, and the third light emitting diode 21c may be a red light emitting diode.

As another example, when each of the plurality of light emitting diodes 21 constitutes a light emitting device 20, only some of a plurality of light emitting devices 20 may include a wavelength conversion material. For example, the light emitting device 20 constituted by the first light emitting diode 21a may be free from the wavelength conversion material and at least one of the light emitting devices 20 constituted by the second or third light emitting diode 21b or 21c may include the wavelength conversion material. For example, the first light emitting diode 21a may constitute a blue light emitting device 20, the second light emitting diode 21b may constitute a green light emitting device 20, and the third light emitting diode 21c may constitute a light emitting device 20 including the red wavelength conversion material. Through this, the design complexity can be reduced.

Alternatively, the first light emitting diode 21a may constitute a blue light emitting device 20, the second light emitting diode 21b may constitute a light emitting device 20 including a green wavelength conversion material, and the third light emitting diode 21c may constitute a red light emitting device 20. Through this, the red color representation capability of the light emitting device 100 can be enhanced.

As another example, two of the light emitting diodes 21 may include the wavelength converting material. For example, the light emitting device 20 constituted by the first light emitting diode 21a may be free from the wavelength conversion material, the light emitting device 20 constituted by the second light emitting diode 21b may include the green wavelength conversion material, and the light emitting device 20 constituted by the third light emitting diode 21c may include the red wavelength conversion material. Through this, the red color representation capability of the light emitting device 100 can be enhanced.

The wavelength conversion material may be provided in the form of covering only some of the light emitting diodes 21, in the form of a film-shaped membrane, in the form of dotting or partial molding, or in the form of partitions surrounding some of the light emitting diodes 21 and fillers filling a portion of the partitions.

In addition, the light emitting diode 21 not covered with the wavelength conversion material may include a transparent molding, without being limited thereto. Through this, the vivid color can be represented by the light emitting device 100. Furthermore, the spectrum of light emitted from the light emitting diode 21 covered with the wavelength conversion material may have a greater full width at half maximum (FWHM) than the spectrum of light emitted from the light emitting diode 21 not covered with the wavelength conversion material. The light emitting deiode 21 covered with the wavelength conversion material can expand the representable color gamut through a wide spectral half-width.

Further, the overall width of the spectrum of the light emitted from the light emitting diode 21 covered with the wavelength conversion material may be greater than the overall width of the spectrum of the light emitted from the light emitting diode 21 not covered with the wavelength conversion material. By using both the light emitting diode 21 with a wide spectrum and the light emitting diode 21 with a narrow spectrum, both color gamut representation and clarity can be improved.

Further, the light emitted from the light emitting diode 21 covered with the wavelength conversion material may have a longer peak wavelength than the light emitted from the light emitting diode 21 not covered with the wavelength conversion material.

Furthermore, the maximum inclination of the spectrum of the light emitted from the light emitting diode 21 covered with the wavelength conversion material may be greater than the maximum inclination of the spectrum of the light emitted from the light emitting diode 21 not covered with the wavelength conversion material. In this way, when the wavelength conversion material is selectively applied, the light emitting device can achieve the spectrum in a predetermined wavelength region, thereby improving wavelength conversion efficiency.

Since the light emitting device 20 according to the fifth embodiment emits blue light, green light, and red light through the light emitting diodes 21, the wavelength converter 22 covering the entire light emitting device 20 may be omitted. Thereby it can reduce material costs.

The light emitting device 20 may include a light transmitting molding filling the cavity instead of the wavelength converter 22. The light emitting device 20 can improve light extraction efficiency through the light transmitting molding.

The light emitting devices 20 according to the above embodiments of the disclosed technology can emit light having various spectra depending on the type of light emitting diode 21 or the composition of the wavelength converter 22.

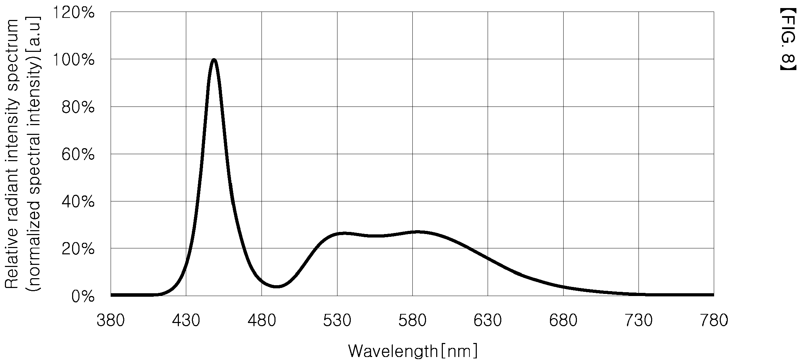

By way of example, FIG. 8 shows one example of a relative radiant intensity spectrum (normalized spectral radiant intensity) of light emitted from a light emitting device 20 according to the embodiments of Fig. 3 to Fig. 7 of the disclosed technology. For example, the light emitting device 20 may be a second embodiment (Fig. 4) or third embodiment (Fig. 5) of the disclosed technology. The spectrum of Fig. 8 may be the relative spectral radiant intensity spectrum of the emitted light from the light emitting device 20 that includes a blue light emitting diode 21 and a wavelength converter 22 with the green and red wavelength conversion materials. Alternatively, the light emitted from the light emitting device 20 may have a relative radiant intensity spectrum of an embodiment in which the light emitting device includes a multi-peak light emitting diode 21 having peak wavelengths in the blue wavelength region and the green wavelength region, and a wavelength converter 22 including the red wavelength conversion material.

Referring to FIG. 8, the emitted light is a mixture of light emitted from the light emitting diode 21 and light generated by the wavelength converter 22, and may have peak wavelengths in the blue wavelength region (400 nm to 480 nm), the green wavelength region (480 nm to 590 nm), and the red wavelength region (590 nm to 750 nm), respectively.

In the blue wavelength region (400 nm to 480 nm), the peak wavelength may be formed between 440 nm and 457.5 nm or between 460 nm and 470 nm; in the green wavelength region (480 nm to 590 nm), the peak wavelength may be formed between 530 nm and 545 nm; and in the red wavelength region (590 nm to 750 nm), the peak wavelength may be formed between 615 nm and 645 nm.

As shown in FIG. 8, the emitted light has the greatest radiant intensity at a peak wavelength in the blue wavelength region (400 nm to 480 nm), which may be greater than or equal to 4 times the radiant intensity at a peak wavelength in the green wavelength region or at a peak wavelength in the red wavelength region. The wavelength converter 22 of the light emitting device 20 may include an area where green or red fluorescent particles are not arranged, allowing blue light to pass through without being excited by the phosphor. Additionally, to enhance the radiant flux in the blue region, the light emitting diode 21 may use a blue light emitting diode with a narrow spectral width and high peak intensity. At this time, a light emitting diode 21 with a peak spectral half-width of less than 20 nm may be adopted. Through this, the light emitting device 20 can implement vivid blue light.

Here, the radiant flux in each color gamut band may be different from that in another color gamut. In addition, a radiant flux in the blue wavelength region 400 nm to 480 nm) may be greater than a radiant flux in the green wavelength region (480 nm to 590 nm) or the red wavelength region (590 nm to 750 nm). The radiant flux in the blue wavelength region may be less than the sum of the radiant fluxes in the green and red wavelength regions. Here, the radiant flux in the blue wavelength region may be less than 50% of the total radiant flux. In addition, the sum of the quantities of light (lm) in the green and red wavelength regions may be greater than or equal to 52% of the total quantity of light. Further, the ratio of blue, green and red radiant fluxes may be 3:2:1, 2:2:1, 2:1:1, or 2:1:1. Since the human eye has the lowest ratio of blue cone cells compared to other cone cells, this structure provides the highest radiant flux in the blue wavelength region. As a result, it is possible to achieve a uniform color intensity as perceived by the human eye. The wavelength converter 22 of the light emitting device 20 may include an area where green or red fluorescent particles are not arranged, allowing blue light to pass through without being excited by the phosphor. Additionally, to enhance the radiant flux in the blue region, the light emitting diode 21 may use a blue light emitting diode with a narrow spectral width and high peak intensity. At this time, a light emitting diode 21 with a peak spectral half-width of less than 20 nm may be adopted. Through this, the light emitting device 20 can implement vivid blue light.

When the wavelength converter 22 includes a fluoride compound phosphor, for example, KSF, as the red wavelength conversion material, a peak wavelength in the red wavelength region may have a narrower full width at half maximum than peak wavelengths in other wavelength regions and a spectrum formed in the red wavelength region may have a higher peak intensity than a spectrum formed in the green wavelength region due to the characteristics of the fluoride compound phosphor. In addition, a plurality of peaks may be formed in the red wavelength region. A narrow peak wavelength in the red wavelength region can realize a clearer red color. As a result, it is possible to improve a color reproduction rate of a display.

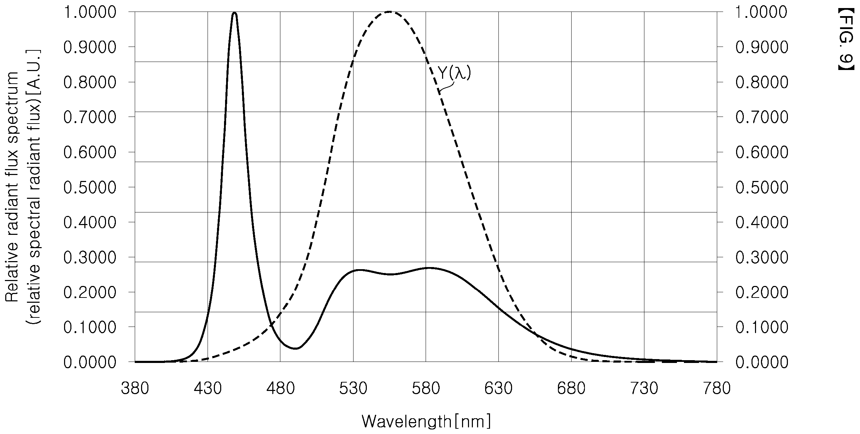

Referring to FIG. 9, it should be considered that the human eye is affected by a spectral luminous efficacy curve ($Y(\lambda)$) instead of perceiving a relative radiant flux spectrum (spectral radiant flux) of light emitted from the light emitting device 20.

Specifically, the spectral luminous efficacy curve ($Y(\lambda)$) refers to a plot of brightness in each wavelength perceived by the human eye when receiving the same amount of energy. The human eye can detect wavelengths in the wavelength region of 380 nm to 760 nm and has maximum visual sensitivity at a wavelength of 555 nm. Here, the green wavelength region (480 nm to 590 nm) may have the highest visual sensitivity, the red wavelength region (590 nm to 750 nm) may have the next highest visual sensitivity, and the blue wavelength region (400 nm to 480 nm) may have the lowest visual sensitivity. The visual sensitivity in the blue wavelength region may be less than the sum of the visual sensitivities in the green and red wavelength regions. Here, an area of the visual sensitivity in the blue wavelength region may be less than 10% of the total quantity of light. In addition, an area of the visual sensitivity in the green wavelength region may be 70% or more, and an area of the visual sensitivity in the red wavelength region may be less than 30%. The area of the visual sensitivity in the blue wavelength region may be less than 5% of the area of the visual sensitivity in the green wavelength region. The area of the visual sensitivity in the red wavelength region may be less than 35% of the area of the visual sensitivity in the green wavelength region. Therefore, the light emitting apparatus should have the highest ratio of radiant flux in the blue wavelength region to increase the color reproduction rate.

Efficiency of a light source can be calculated using the spectral luminous efficacy curve ($Y(\lambda)$). The spectral luminous efficacy curve ($Y(\lambda)$) takes into account influence of wavelengths at the same power and the total luminous flux $\Phi_v(x_\lambda)$) can be calculated by multiplying the power density spectrum $\Phi_{e,\lambda}(\lambda)$ (light output at unit wavelength) by the spectral luminous efficacy curve ($Y(\lambda)$), followed by integrating the multiplied value over the wavelength, as in Equation 1:

$$\Phi_v(x_\lambda) = 683.002 \cdot \int_a^b \overline{y}(\lambda)\Phi_{e,\lambda}(\lambda)d\lambda \qquad \text{Equation (1)}$$

where $\lambda$ indicates the wavelength.

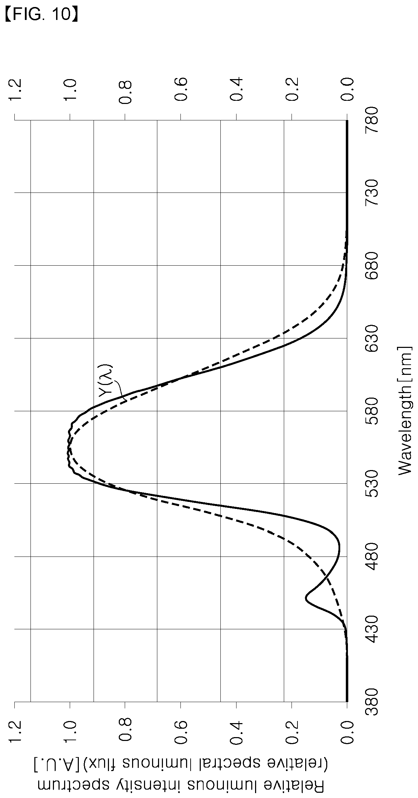

FIG. 10 shows relative luminous intensity spectrum (spectral luminous intensity) of light emitted from the light emitting device 20, which takes into account the influence of the spectral luminous efficacy curve ($Y(\lambda)$).

According to Equation 1, the total luminous flux at wavelengths from 400 nm to 750 nm ($L_{out}(x_\lambda)$) (total luminous flux) may be calculated according to Equation 2:

$$L_{out}(x_\lambda) = 683.002 \cdot \int_{400}^{750} \overline{y}(\lambda)\Phi_{e,\lambda}(\lambda)d\lambda. \qquad \text{Equation (2)}$$

Given that the blue wavelength region is in the range of 400 nm to 480 nm, the luminous flux in the blue wavelength region ($L_b(x_\lambda)$) may be calculated according to Equation 3:

$$L_b(x_\lambda) = 683.002 \cdot \int_{400}^{480} \overline{y}(\lambda)\Phi_{e,\lambda}(\lambda)d\lambda. \qquad \text{Equation (3)}$$

Given that the green wavelength region is in the range of 480 nm to 590 nm, the luminous flux in the green wavelength region ($L_g(x_\lambda)$) may be calculated according to Equation 4:

$$L_g(x_\lambda) = 683.002 \cdot \int_{480}^{590} \overline{y}(\lambda)\Phi_{e,\lambda}(\lambda)d\lambda. \qquad \text{Equation (4)}$$

Given that the red wavelength region is in the range of 590 nm to 750 nm, the luminous flux in the red wavelength region ($L_r(x_\lambda)$) may be calculated according to Equation 5:

$$L_r(x_\lambda) = 683.002 \cdot \int_{590}^{750} \overline{y}(\lambda)\Phi_{e,\lambda}(\lambda)d\lambda. \qquad \text{Equation (5)}$$

Using Equations 1 to 5, the luminous flux ratios for the blue wavelength region, the green wavelength region, and the red wavelength region can be derived.

The luminous flux in the blue wavelength region (400 nm to 480 nm) ($L_b(x_\lambda)$) may be in the range of 0.01 times to 0.1 times the total luminous flux $L_{out}(x_\lambda)$ (wavelength of 400 nm to 750 nm) of light emitted from the light emitting device 20.

The luminous flux in the green wavelength region (480 nm to 590 nm) ($L_g(x_\lambda)$) may be in the range of 0.7 times to 0.89 times the total luminous flux $L_{out}(x_\lambda)$ (wavelengths 400 nm to 750 nm) of the light emitted from the light emitting device 20. The luminous flux in the green wavelength region (480 nm to 590 nm) ($L_g(x_\lambda)$) may be in the range of 20 times to 90 times the luminous flux in the blue wavelength region (400 nm to 480 nm) ($L_b(x_\lambda)$). To implement this, the wavelength converter 22 may include a green phosphor for converting light from the blue wavelength range to the green wavelength region. The green phosphor may include at least one of LuAG series, YAG series, beta-SiAlON series, nitride series, silicate series, halophosphate series, or oxynitride series.

The luminous flux in the red wavelength region (590 nm to 750 nm) ($L_r(x_\lambda)$) may be in the range of 0.15 times to 0.3 times the total luminous flux $L_{out}(x_\lambda)$ (wavelength of 400 nm to 750 nm) of the light emitted from the light emitting device 20. The luminous flux in the red wavelength region (590 nm to 750 nm) ($L_r(x_\lambda)$) may be in the range of 3 times to 30 times the luminous flux in the blue wavelength region (400 nm to 480 nm) ($L_b(x_\lambda)$). To implement this, the wavelength converter 22 may further include a red phosphor that converts a portion of the light from the blue wavelength region to the red wavelength region. The red phosphor may include nitride-based phosphors (such as CaAlSiN, SrCaSiN, SrSiN, etc.), aluminate-based phosphors (such as $(Sr,Ba)Al_2O_4$, etc.), fluoride-based compounds (such as KSF ($K_2SiF_6$:Mn), etc.), or quantum dots (QD) emitting red light. Additionally, the wavelength converter 22 may further include a yellow phosphor that converts a portion of the light from the blue wavelength region to the yellow wavelength region. The yellow phosphor may include YaG, TaG, or orthosilicate-based phosphors.

As such, by varying the ratio of luminous flux in each wavelength region of the emitted light, the light emitting apparatus can achieve a high color reproduction rate within the color coordinates.

On the other hand, the light emitted from the light emitting device 20 may be emitted after passing through the color filter 150, as shown in FIG. 1A to FIG. 1B.

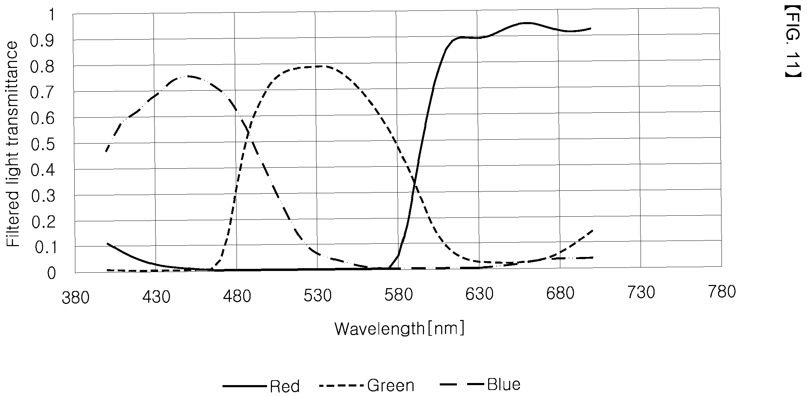

The color filter 150 has a filter transmittance for each color, as shown in FIG. 11, and the transmittance of the color filter 150 may vary according to design or specifications.

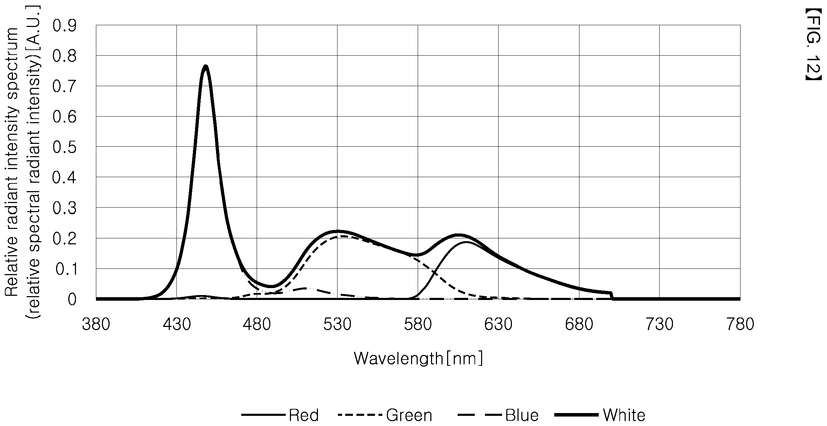

FIG. 12 shows an example of relative radiant intensity spectra (spectral radiant intensity) of light emitted from the light emitting device 20 and having passed through the color filter 150.

When the radiant intensity spectrum of light emitted from the light emitting device 20 is denoted by $Lin(x_k)$, the blue transmittance of the color filter 150 is denoted by $F_{blue}(xk)$, the green transmittance of the color filter 150 is denoted by $F_{green}(xk)$, and the red transmittance of the color filter 150 is denoted by $F_{red}(xk)$), a blue wavelength region radiant intensity spectrum $Lin_{f\_b}(x_\lambda)$, a green wavelength region radiant intensity spectrum $Lin_{f\_g}(x_\lambda)$, a red wavelength region radiant intensity spectrum $Lin_{f\_r}(x_\lambda)$, and the total radiant intensity spectrum $Lin_{f\_rgb}(x_\lambda)$) may be calculated according to Equations 6 to 9, respectively:

$$Lin_{f\_b}(x_\lambda) = Lin(x_\lambda) \cdot F_{blue}(x_\lambda), \qquad \text{Equation (6)}$$

$$Lin_{f\_g}(x_\lambda) = Lin(x_\lambda) \cdot F_{green}(x_\lambda), \qquad \text{Equation (7)}$$

$$Lin_{f\_r}(x_\lambda) = Lin(x_\lambda) \cdot F_{red}(x_\lambda), \qquad\qquad \text{Equation (8)}$$

$$Lin_{f\_rgb}(x_\lambda) = Lin_{f\_r}(x_\lambda) + Lin_{f\_g}(x_\lambda) + Lin_{f\_b}(x_\lambda). \qquad \text{Equation (9)}$$

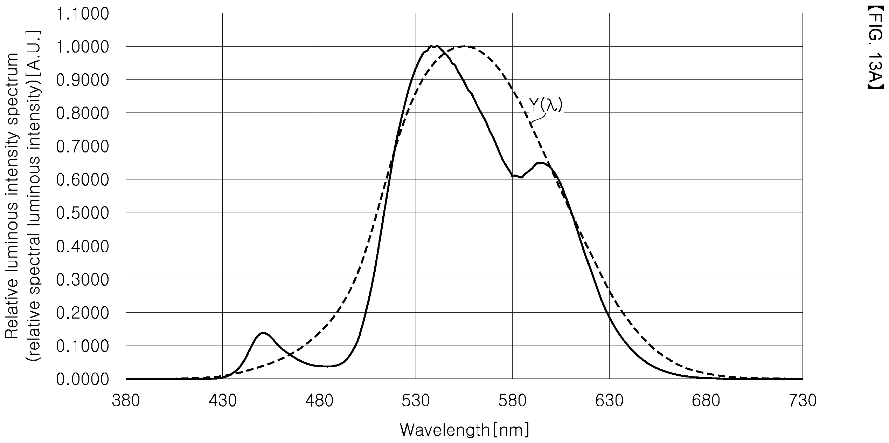

Since the human eye does not perceive the light having passed through the color filter 150 or the relative radiant intensity spectrum per se, the influence of the spectral luminous efficacy curve ($Y(\lambda)$) must be considered. FIG. 13A shows the relative luminous intensity spectrum (spectral luminous intensity) of the transmitted light, as obtained by taking into account the influence of the spectral luminous efficacy curve ($Y(\lambda)$). Compared to FIG. 10, it can be observed that the luminous flux in the region between the green wavelength region and the red wavelength region is reduced due to the influence of the color filter 150. As such, by reducing the luminous flux in the region between the green wavelength region and the red wavelength region, the color reproduction rate can be increased by dividing two color gamut bands.

Referring back to Equations 1 to 5, the luminous flux ratio of the transmitted light in each of the blue wavelength region, the green wavelength region, and the red wavelength region can be derived.

The luminous flux $L_{f\_b}(x_\lambda)$ in the blue wavelength region (400 nm to 480 nm) may be in the range of 0.02 times to 0.06 times, more preferably 0.03 times to 0.05 times, the total luminous flux $L_{f\_out}(x_\lambda)$ (wavelength of 400 nm to 750 nm) of the transmitted light having passed through the color filter 150. By maintaining this ratio, it is possible to represent white while preserving blue color reproduction. However, if the proportion of the blue wavelength region increases relative to other regions, it may cause eye damage due to blue light, so it is necessary to maintain this ratio. To implement this, the transmittance of the blue light region of the color filter 150 may be lower than that of other wavelength regions, as shown in FIG. 11.

The luminous flux $L_{f\_g}(x_\lambda)$ in the green wavelength region (480 nm to 590 nm) may be in the range of 0.62 times to 0.72 times, more preferably 0.63 times to 0.71 times, the total luminous flux $L_{f\_out}(x_\lambda)$ (wavelength of 400 nm to 750 nm) of the transmitted light having passed through the color filter 150. By maintaining this ratio, it is possible to represent white while preserving green color reproduction. On the other hand, if the proportion of green light increases compared to other regions, the yellow/green ratio in white light may increase, leading to a decrease in white light reproduction. To implement this, the transmittance of the green light region of the color filter 150 may be higher than that of the blue region and lower than that of the red region, as shown in FIG. 11. Additionally, considering human vision, the transmittance half-width of the green light region of the color filter 150 may be designed to be wider than that of the blue wavelength, thereby increasing the overall luminous flux.

The luminous flux $L_{f\_r}(x_\lambda)$ in the red wavelength region (590 nm to 750 nm) may be in the range of 0.14 times to 0.27 times, more preferably between 0.15 times to 0.26 times, the total luminous flux $L_{f\_out}(x_\lambda)$ (wavelength of 400 nm to 750 nm) of the transmitted light having passed through the color filter 150. By maintaining this ratio, it is possible to represent white while preserving red color reproduction. In particular, for display devices or lighting, vivid red reproduction is required to enhance color vividness. To implement this, the transmittance of the red light region of the color filter 150 may be higher than that of other color regions, as shown in FIG. 11. Additionally, the transmittance half-width of the red region filter may be designed to be wider than that of other wavelength regions. This enables the representation of rich red colors.

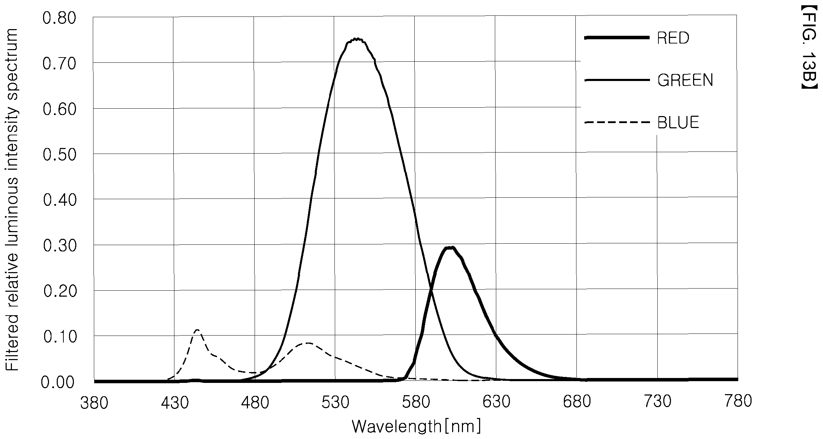

FIG. 13B shows one example of a relative luminous intensity spectrum according to the luminous flux $L_{f\_b}(x_\lambda)$ in blue wavelength region, a relative luminous intensity spectrum according to the luminous flux $L_{f\_g}(x_\lambda)$ in green wavelength region, and a relative luminous intensity spectrum according to the luminous flux $L_{f\_r}(x_\lambda)$ in red wavelength region of transmitted light. Each spectrum has passed through its respective blue, green, or red color filter 150. The relative luminous intensity spectrum $L_{f\_b}(x_\lambda)$ in the blue wavelength region may overlap the relative luminous intensity spectrum in the green wavelength region. The relative luminous intensity spectrum $L_{f\_g}(x_\lambda)$ in the green wavelength region may partially overlap the relative luminous intensity spectra in the blue and red wavelength regions. The relative luminous intensity spectrum $L_{f\_r}(x_\lambda)$ in the red wavelength region may partially overlap the relative luminous intensity spectrum in the green wavelength region. As a result, it is possible to improve the luminous intensities in the red and blue wavelength regions, which have relatively low luminous intensities.

The area of the relative luminous intensity spectrum in the blue wavelength region may be larger than or equal to 5% and less than 15% of the area of the luminous intensity spectrum according to the total luminous flux $L_{f\_out}(x_\lambda)$. The area of the relative luminous intensity spectrum in the green wavelength region may be larger than or equal to 60% and less than 80%. The area of the relative luminous intensity spectrum in the red wavelength region may be larger than or equal to 10% and less than 30%. The green region may have the highest luminous intensity, followed by the luminous intensity in the blue region, and then the luminous intensity in the red region. For example, the ratio of the luminous intensity in the blue wavelength region, the luminous intensity in the green wavelength region, and the luminous intensity in the red wavelength region to the total luminous intensity may be 1:7:2. This ensures the ability to achieve white representation while satisfying the color gamut for red, green, and blue.

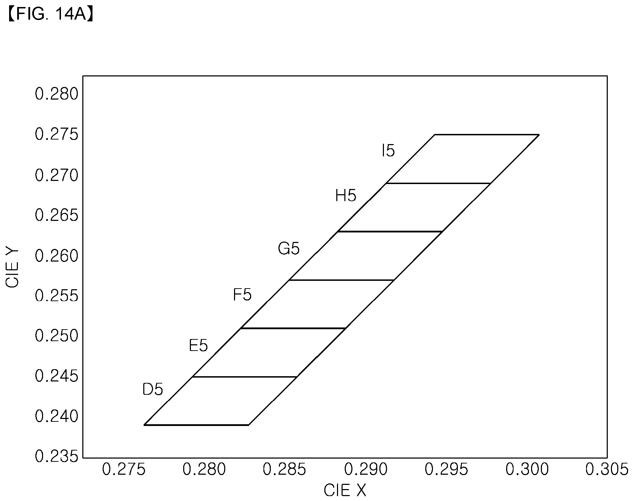

Here, the total luminous flux $L_{f\_out}(x_\lambda)$ may have color coordinates in a white region shown in FIG. 14A. This ensures the ability to achieve white representation.

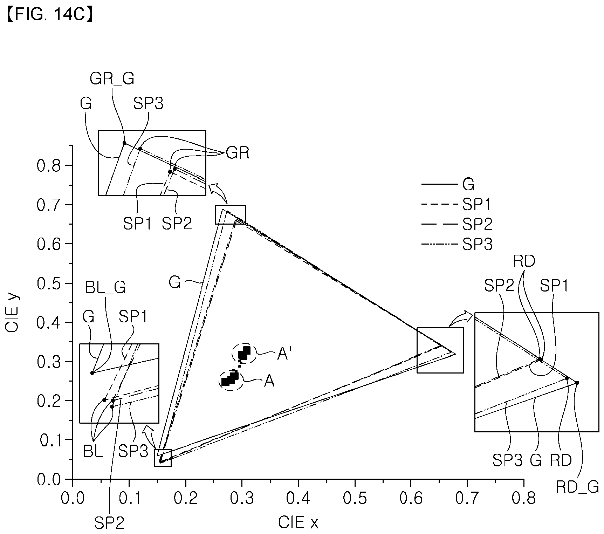

In addition, the luminous spectrum of the blue wavelength region can have the blue color coordinate (BL) shown in Fig. 14C. The x-coordinate value of the blue color coordinate (BL) may be greater than the x-coordinate value of the reference G blue color coordinate (BL_G), and the y-coordinate value of the blue color coordinate (BL) may be smaller than the y-coordinate value of the reference G green color coordinate (BL_G). The color coordinates of the blue wavelength region can be located in the lower-left region of the white area (A') in Fig. 14C. The x-coordinate value of the blue color coordinate (BL) can range from 0.14 to less than 0.17, and the y-coordinate value can range from 0.03 to 0.07. Through this, it is possible to manufacture the light emitting device 100 with maintained color reproducibility while keeping the design cost low.

The luminous spectrum of the green wavelength region can have the green color coordinate (GR) shown in Fig. 14C. The x-coordinate value of the green color coordinate (GR) may be greater than the x-coordinate value of the reference G green color coordinate (GR_G), and the y-coordinate value of the green color coordinate (GR) may be smaller than the y-coordinate value of the reference G green color coordinate (GR_G). The color coordinates of the green wavelength region can be located in the upper region of the white area (A') in Fig. 14C. The x-coordinate value of the green color coordinate (GR) can range from 0.25 to less than 0.3, and the y-coordinate value can range from 0.6 to less than 0.7. Through this, it is possible to manufacture the light emitting device 100 with maintained color reproducibility while keeping the design cost low.

The luminous spectrum of the red wavelength region can have the red color coordinate (RD) shown in Fig. 14C. The x-coordinate value of the red color coordinate (RD) may be smaller than the x-coordinate value of the reference G red color coordinate (RD_G), and the y-coordinate value of the red color coordinate (RD) may be greater than the y-coordinate value of the reference G red color coordinate (RD_G). The color coordinates of the red wavelength region can be located in the right region of the white area (A') in Fig. 14C. The x-coordinate value of the red color coordinate (RD) can range from 0.6 to less than 0.7, and the y-coordinate value can range from 0.3 to less than 0.4. Through this, it is possible to manufacture the light-emitting device 100 with maintained color reproducibility while keeping the design cost low.

As described above, a high color reproduction rate within the color coordinates can be obtained by varying the ratio of the luminous flux of the emitted light in each wavelength region.

The light emitted from the light emitting device 20 according to the embodiment of the disclosed technology may have color coordinates within the CIE color coordinates shown in FIG. 14A. The transmitted light may have color coordinates within color coordinates from D5 to I5 according to the correlated color temperature (CCT). The light may be white light emitted from the light emitting device 20, which may emit a mixture of light in the red wavelength region, light in the green wavelength region, and light in the blue wavelength region in a certain ratio. When the light in the three wavelength regions is emitted in a certain ratio, the light can be converted into red, blue, and green light through the color filter 150. Accordingly, a light emitting device 100 with high color reproduction can be implemented.

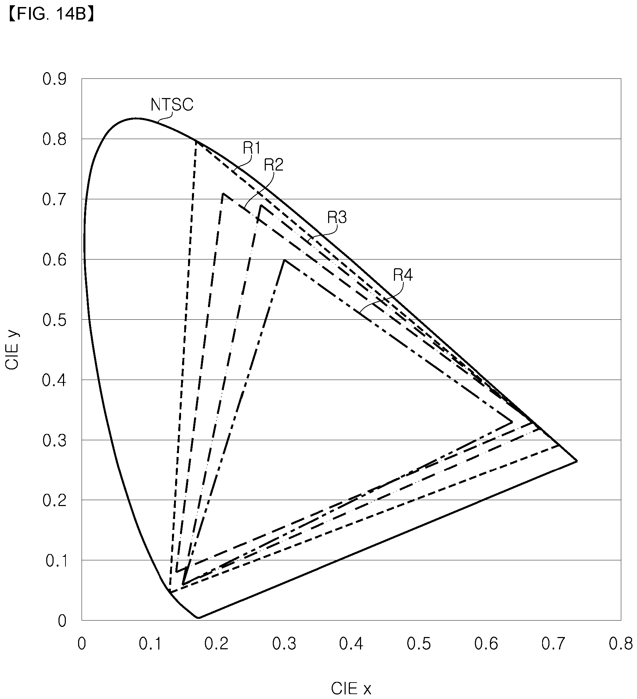

FIG. 14B shows color gamut of various standards. R1 to R4 are color gamut standards proposed for television broadcasting. Here, R2 shows the color gamut of the National Television System Committee (NTSC). In addition to NTSC, there are PAL (Phase Alternating by Line), SECAM (System Electronique Memoire), and others proposed for television broadcasting. R1 is the International Telecommunication Union (ITU) recommended 4K/UHD standard (BT2020 or Rec.2020), which is an expanded color gamut compared to R2 and represents a wider color gamut.

R3 is the DCI-P3 (Digital Cinema Initiatives-P3) color gamut and R4 may be sRGB (Standard Composite RGB), which is the high-definition television (HDTV) broadcast standard. A wider color gamut provides a wider Representable range. Accordingly, a wider range of color representations can be achieved.

The color gamut may be changed for the transmitted light having passed through the color filter 150. Table 1 shows changes in color coordinates before and after passing through the color filter 150 for three samples SP1, SP2, SP3 of the light emitting apparatus 100 configured to emit white light. Here, SP 1 and SP2 may indicate light emitting apparatuses 100 including a blue light emitting device 20 and yellow and red wavelength converter 22, and SP 3 may indicate a light emitting apparatus 100 including a blue light emitting device 20 and green and red wavelength converter 22. In particular, the light emitting apparatus 100 indicated by SP 3 may include KSF as the red wavelength conversion material.

Table 1

| NO. | Before passing through color filter | | | After passing through color filter | | | | | | | | |
|---|---|---|---|---|---|---|---|---|---|---|---|---|
| | Light Source (white) | | | Red | | Green | | Blue | | White | | |
| | x | y | lv | X | y | x | y | x | y | x | y | lv |
| SP 1 | 0.2821 | 0.2526 | 1652.36 | 0.6562 | 0.3415 | 0.2888 | 0.6612 | 0.1530 | 0.0454 | 0.3043 | 0.3138 | 102.6 |
| SP 2 | 0.2873 | 0.2630 | 1778.06 | 0.6550 | 0.3426 | 0.2912 | 0.6640 | 0.1549 | 0.0449 | 0.3101 | 0.3283 | 110.3 |
| SP 3 | 0.2729 | 0.2467 | 3997.05 | 0.6730 | 0.3245 | 0.2732 | 0.6849 | 0.1548 | 0.0418 | 0.3016 | 0.3160 | 258.8 |

Referring to Table 1, it can be seen that both the x and y values of the color coordinates of the white light increase after the light has passed through the color filter 150.

Before and after passing through the color filter 150, the x and y values of the color coordinates of red, green, and blue colors may also be changed and a gamut ratio with reference to a certain color gamut may be determined according to the color coordinates. Specifically, the gamut ratio may include a color gamut area ratio and a coverage for the transmitted light that has passed through the color filter 150.

The color gamut area ratio may be defined as an area ratio of a color gamut of light having passed through the color filter 150 to a reference color gamut. The coverage refers to a ratio of an overlapping area between the color gamut of a reference color and the color gamut of light having passed through the color filter 150 to the area of the reference color gamut and may be defined as the color reproduction rate.

The color gamut area ratio may have a value of 80% or more. More preferably It may have a value of 85% or more. The coverage may have a value of 80% or more, more preferably 85% or more.

Referring again to FIG. 14C, it can be seen that x and y values of the red, green, and blue color coordinates in the CIE1931 coordinates are changed (from A before passage to A' after passage) before and after white light emitted from the light emitting device 20 passes through the color filter 150. In FIG. 14C, G shows one example of DCI-P3, which is one of color gamut standards represented in the CIE color coordinate system. However, the disclosed technology is not limited thereto and the color coordinates may be determined based on color references of R1 to R4 shown in FIG. 14B, which shows the color coordinates after the light passes through the color filter 150 for each of SP 1 to SP 3 that are the light emitting devices 20 configured to emit white light.

All of SP 1 to SP 3 may exhibit upward-right shift in color coordinates from $(X_1, Y_1)$ before passing through the color filter 150 to $(X_2, Y_2)$ after passing through the color filter 150. That is, the X coordinate value of the color coordinates may be increased. An increment of the X coordinate value may be in the range of 0.02 and 0.04, indicating a wavelength shift in a red direction (red shift). Similarly, the Y coordinate value of the color coordinates may be increased, indicating a wavelength shift in a green direction (green shift). An increment of the Y coordinate value may be in the range of 0.05 and 0.08. By managing the white shift rate to be small, white purity can be maintained even after the light passes through the color filter 150. To this end, an area of the luminous intensity spectrum in the blue wavelength region may be between 5% and less than 15% of the total luminous intensity spectrum area after transmission through the color filter 150. The area of the luminous intensity spectrum in the green wavelength region may be between 60% and less than 80% of the total luminous intensity spectrum area. The area of the luminous spectrum in the red wavelength region may be between 10% and less than 30% of the total luminous intensity spectrum area.

All of SP 1 and SP 3 may exhibit shifting to the red gamut after the light has passed through a red filter of the color filter 150, and the red color coordinates RD (Xr, Yr) may have a lower x-coordinate value and a higher y-coordinate value than the red color coordinates RD_G of Reference G. Here, a change in x-coordinate value may range from 0.0 to -0.035. A change in y-coordinate value may range from 0.0 to +0.035. This result indicates that the transmitted light is shifted to a shorter wavelength side after passing through the red filter. As a result, the light emitting apparatus 100 can emit light as a red color that is perceived to be bright by humans.

In addition, all of SP 1 and SP 3 may exhibit shifting to the green gamut after the light has passed through a green filter of the color filter 150, and the green color coordinates GR (Xg, Yg) may have a higher x-coordinate value and a lower y-coordinate value than the green color coordinates GR_G of Reference G. Here, a change in x-coordinate value may range from 0.0 to +0.035. A change in y-coordinate value may range from 0.0 to -0.035. This result indicates that the light is shifted toward a longer wavelength side after passing through the green filter. As a result, the light emitting apparatus 100 can realize a clear, efficient green color within the visible range.

Further, all of SP 1 and SP 3 may exhibit shifting to the blue gamut after the light has passed through the blue filter, and the blue color coordinates BL (Xb, Yb) may have a higher x-coordinate value and a lower y-coordinate value than the blue color coordinates BL_G of Reference G. Here, a change in x-coordinate value may range from 0.0 to +0.01. A change in y-coordinate value may range from 0.0 to -0.02. This result indicates that the light is shifted toward a longer wavelength side after passing through the blue filter. The change rate in the blue gamut may be smaller than in other gamut bands. As a result, the light emitting apparatus 100 can realize a blue color with high clarity.

Accordingly, the color gamut area ratio and the coverage may be calculated for each of SP 1, 2, and 3, as shown in Table 2 below.

Table 2

| NO. | After passing through color filter | |
| --- | --- | --- |
| | Area ratio (%) | Coverage (%) |
| SP 1 | 88.7 | 87.89 |
| SP 2 | 88.5 | 87.56 |

(continued)

| NO. | After passing through color filter | |
| --- | --- | --- |
| | Area ratio (%) | Coverage (%) |
| SP 3 | 98.6 | 95.95 |

Here, the area ratio refers to an area ratio of a triangle forming vertices (RD_G, BL_G, GR_G) of the color coordinates of the color gamut of each of red, green, and blue colors of Reference G to a triangle forming vertices (RD, BL, GR) of the color coordinates of the color gamut of each of red, green, and blue colors of SP 1 to SP 3.

The coverage refers to an area ratio of an overlapping region between the triangle forming the vertices (RD, BL, GR) of the color coordinates of each of red, green, and blue colors of SP 1 to SP 3 and the triangle forming the vertices (RD_G, BL_G, GR_G) of the color coordinates of each of red, green, and blue colors of Reference G. A higher coverage indicates higher similarity to Reference G and can realize a display apparatus with better quality.

Compared to SP 1 and SP 2, it can be seen that SP3 achieves improvement in both the color gamut area ratio and the coverage by applying KSF as the red wavelength conversion material. As a result, the light emitting apparatus has at least one peak in each of the green, red and blue regions, and can realize clear colors through each color filter and color coordinates close to the vertices of the color coordinates of each color of Reference G. Accordingly, a high-quality display device with a wide color gamut can be implemented.

On the other hand, it should be understood that FIG. 8, FIG. 10, and FIG. 13 show only one example of the intensity/luminous intensity spectra of the light emitting apparatus 100 according to the disclosed technology and that the disclosed technology is not limited thereto and may have various types of spectra depending on the kind and number of light emitting diodes 21, the configuration of the wavelength converter 22, transmittance of the color filter 150, or others.

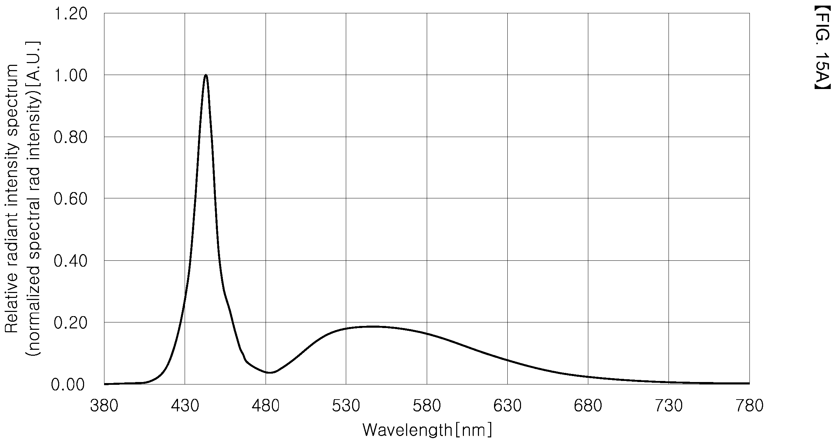

By way of example, FIG. 15A to FIG. 15G show exemplary relative radiant intensity spectra of light emitted from the light emitting devices 20 according to the first to fifth embodiments described above.

First, FIG. 15A shows a relative radiant intensity spectrum of light emitted from the light emitting device 20 according to the first embodiment, in which the light emitting diode 21 of the light emitting device 20 is a blue light emitting diode and the wavelength converter 22 may include the green and yellow wavelength conversion materials.

Referring to FIG. 15A, the relative radiant intensity spectrum may have a peak wavelength with a first radiant intensity in the blue wavelength region (400 nm to 480 nm) and a peak wavelength with a second radiant intensity in the green wavelength region (480 nm to 590 nm), which is less than the first radiant intensity. The first radiant intensity may be greater than or equal to 4 times, more preferably greater than or equal to 5 times, the second radiant intensity. The relative radiant intensity spectrum may exhibit no peak wavelengths in the red wavelength region (590 nm to 750 nm).

It is apparent that the relative radiant intensity spectrum may have a peak wavelength in the red wavelength region (590 nm to 750 nm) when the wavelength converter 22 further includes a red wavelength conversion material. At a peak wavelength in the red wavelength region, the radiant intensity may be less than the first radiant intensity and the second radiant intensity.

A first radiant flux in the blue region may be in the range of 30% to 50% of the total radiant flux. In addition, a second radiant flux in the green region may be in the range of 30% to 40% of the total radiant flux. Further, a third radiant flux in the red region may be in the range of 10% to 30% of the total radiant flux. Furthermore, the third radiant flux may be less than the second radiant flux. A higher radiant flux in the green region allows the light emitting apparatus to achieve a higher luminous flux by emitting a greater quantity of light in the color gamut with higher visual sensitivity. Accordingly, the effect of making a person perceive brightness with the same energy can be achieved. To implement this, the wavelength converter 22 may further include a phosphor for down-converting part of the blue light to green and yellow. To satisfy the above condition, the green and yellow phosphors may be phosphors with a tail extending into the red region. Alternatively, to match the light intensity ratio between the green and red regions, the content of the red phosphor in the wavelength converter 22 may be less than the content of the green phosphor. For example, in a cross-section of the light-emitting device 100, the number of green phosphor particles arranged on the top surface of the light emitting diode 21 may be greater than the number of red phosphor particles.

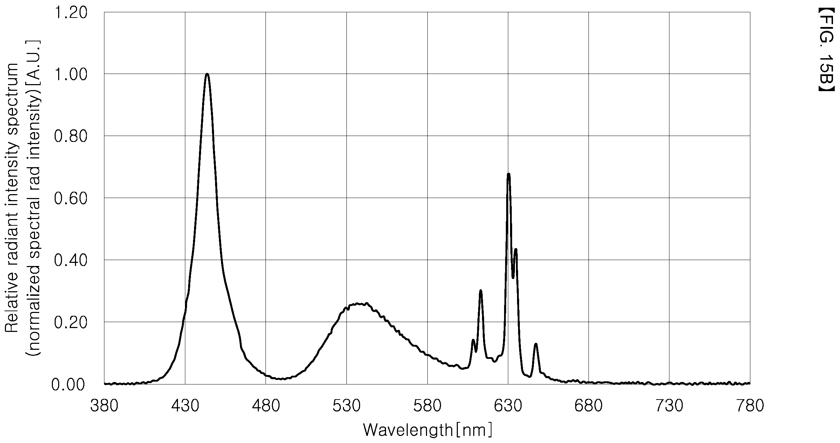

Next, FIG. 15B shows a relative radiant intensity spectrum of light emitted from the light emitting device 20 according to the second embodiment, in which the light emitting diode 21 of the light emitting device 20 is a blue light emitting diode and the wavelength converter 22 may include the green, yellow, and red wavelength conversion materials. Here, the red wavelength conversion material may include a material having a narrow spectrum of excitation wavelengths, such as quantum dots (QD), or a fluoride compound, such as $K_2SiF_6:Mn^{4+}$ (KSF), or others. The disclosed technology is not limited thereto and the light emitting diode 21 of the light emitting device 20 may be a light emitting device 20 that includes a light emitting diode 21 having two or more peaks in the blue and green regions and the red wavelength conversion material in the wavelength converter 22. This may allow for a vivid red color to be represented.

Referring to FIG. 15B, the relative radiant intensity spectrum of the emitted light may have a peak wavelength with a first radiant intensity in the blue wavelength region (400 nm to 480 nm), a peak wavelength (for example, 540 nm) having a second radiant intensity in the green wavelength region (480 nm to 590 nm), which is less than the first radiant intensity, and a peak wavelength in the red wavelength region (590 nm to 750 nm). In addition, the red wavelength region (590 nm to 750 nm) may have a narrower full width at half maximum than the other wavelength regions and may have a plurality of peaks, one of which may be the highest third radiant intensity.

Here, the radiant intensity at the peak wavelength in the red wavelength region may be less than the first radiant intensity and greater than the second radiant intensity. When the full width at half maximum of the red wavelength region is narrow or the radiant intensity in the red wavelength region is high, the light emitting apparatus may realize a clearer red color. Thereby it may improve the color reproduction rate. Here, the first radiant intensity may be greater than the second radiant intensity and the third radiant intensity. In addition, the third radiant intensity may be greater than the second radiant intensity.

Here, the radiant flux in the blue region may be in the range of 30% to 50% of the total radiant flux. In addition, the radiant flux in the green region may be in the range of 30% to 40% of the total radiant flux. Further, the radiant flux in the red region may be in the range of 10% to 30% of the total radiant flux. Further, the radiant flux in the red region may be less than the radiant flux in the green region. A higher radiant flux in the green region allows the light emitting apparatus to achieve a higher luminous flux by emitting a greater quantity of light in the color gamut with higher visual senstivitiy. Thereby it may have the effect of making a person perceive greater brightness at the same energy. As described above, the light emitting apparatus can compensate for difference in luminosity by making the first radiant intensity higher than the second radiant intensity. Thereby having the effect of making a person perceive similar brightness.

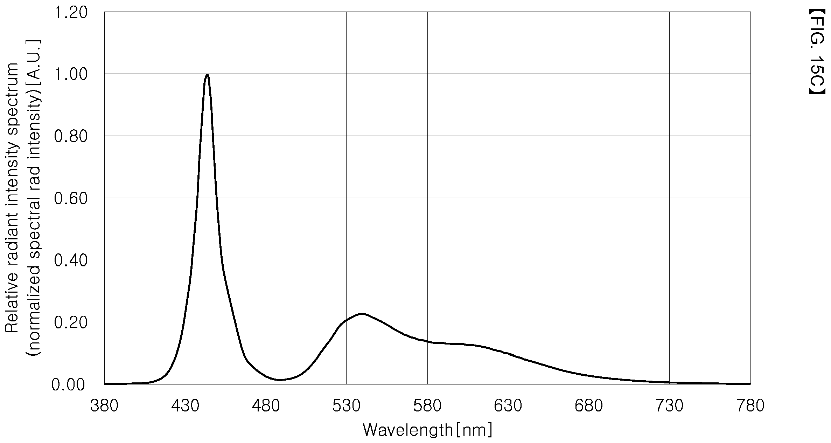

Next, FIG. 15C shows a relative radiant intensity spectrum of light emitted from the light emitting device 20 according to the third embodiment, in which the light emitting diode 21 of the light emitting device 20 is a blue light emitting diode and the wavelength converter 22 may include the green, yellow, and red wavelength conversion materials.

Referring to FIG. 15C, the relative radiant intensity spectrum of the emitted light may have a peak wavelength with a first radiant intensity in the blue wavelength region (400 nm to 480 nm), a peak wavelength (for example, 540 nm) having a second radiant intensity in the green wavelength region (480 nm to 590 nm), which is less than the first radiant intensity, and a peak wavelength (for example, 620 nm) having a third radiant intensity in the red wavelength region (590 nm to 750 nm), which is less than the second radiant intensity.

Here, the radiant flux in the blue region may be in the range of 30% to 50% of the total radiant flux. In addition, the radiant flux in the green region may be in the range of 30% to 40% of the total radiant flux. Further, the radiant flux in the red region may be in the range of 10% to 30% of the total radiant flux. Further, the radiant flux in the red region may be less than the radiant flux in the green region. A higher radiant flux in the green region allows the light emitting apparatus to achieve a higher luminous flux by emitting a greater quantity of light in the color gamut with visual sensitivity luminosity. Thereby it may have the effect of making a person perceive greater brightness at the same energy. As such, the light emitting apparatus can compensate for difference in luminosity by varying the radiant flux in each color gamut. Thereby it may have the effect of making a person perceive similar brightness.

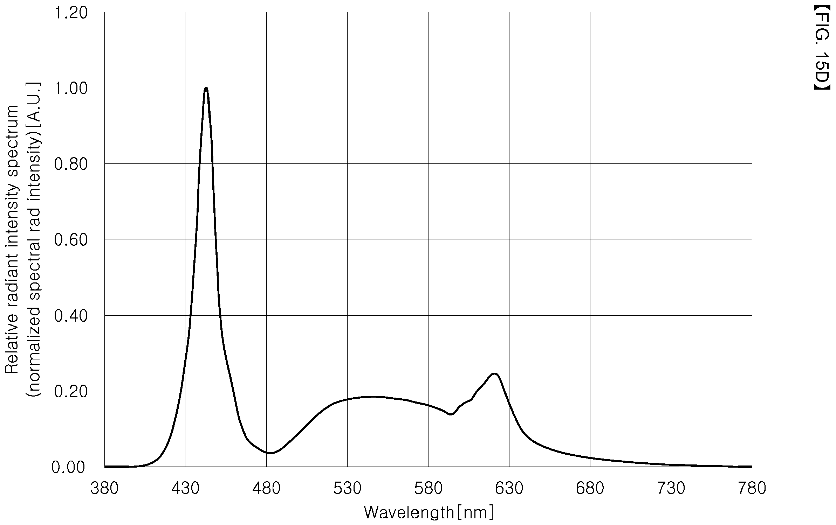

Next, FIG. 15D shows a relative radiant intensity spectrum of light emitted from the light emitting device 20 according to the fourth embodiment, in which the light emitting diode 21 of the light emitting device 20 includes a blue light emitting diode and a red light emitting diode, and the wavelength converter 22 may include at least one of the yellow or green wavelength conversion material. Alternatively, in the light emitting device 20 according to the first embodiment, the light emitting diode 21 may have a plurality of peaks in the blue and red regions, and the wavelength converter 22 may include the yellow or green wavelength conversion material.

Referring to FIG. 15D, the relative radiant intensity spectrum of the emitted light may have a peak wavelength with a first radiant intensity in the blue wavelength region (400 nm to 480 nm), a peak wavelength (for example, 540 nm) having a second radiant intensity in the green wavelength region (480 nm to 590 nm), which is less than the first radiant intensity, and a peak wavelength (for example, 620 nm) having a third radiant intensity in the red wavelength region (590 nm to 750 nm), which is less than the second radiant intensity. Here, the full width at half maximum of the spectrum in the green wavelength region may be greater than the full width at half maximum of the spectrum in the blue wavelength region and may also be greater than the full width at half maximum of the spectrum in the red wavelength region. Here, the light in the green wavelength region may be light converted by the wavelength converter. Further, a plurality of peaks may be formed in the red wavelength region (590 nm to 750 nm).

Here, the radiant flux in the blue region may be in the range of 30% to 50% of the total radiant flux. In addition, the radiant flux in the green region may be in the range of 30% to 40% of the total radiant flux. Further, the radiant flux in the red region may be in the range of 10% to 30% of the total radiant flux. Furthermore, the radiant flux in the red region may be less than the radiant flux in the green region. A higher radiant flux in the green region allows the light emitting apparatus to achieve a higher luminous flux by emitting a greater quantity of light in the color gamut with higher visual sensitivity. Thereby it may have the effect of making a person perceive greater brightness at the same energy. As such, the light emitting apparatus can compensate for difference in luminosity by varying the radiant flux in each color gamut. Thereby it may have the effect of making a person perceive similar brightness.

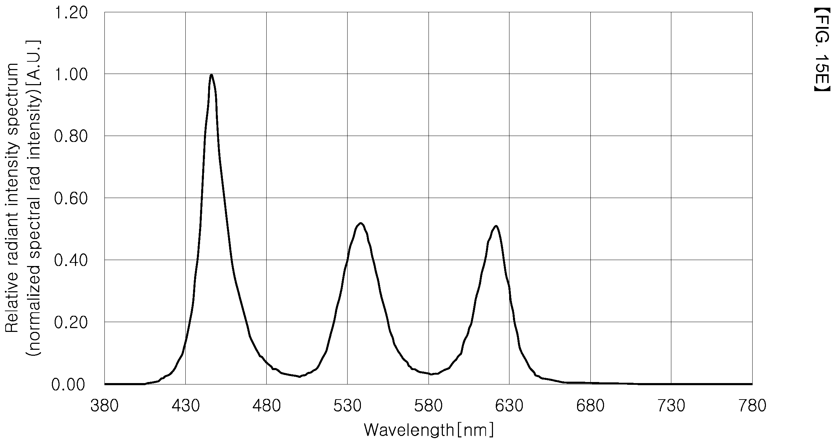

Next, FIG. 15E shows a relative radiant intensity spectrum of light emitted from the light emitting device 20 according to the fifth embodiment, in which the light emitting diode 21 of the light emitting device 20 may include a blue light emitting diode 21a, a green light emitting diode 21b, and a red light emitting diode 21c to have three peak wavelengths. Furthermore, each of the light emitting devices 20 according to the first to third embodiments may include a wavelength converter including at least one of green QDs or red QDs having a narrow spectral half-width on the light emitting diode 21.

Referring to FIG. 15E, the relative radiant intensity spectrum of the emitted light may have a peak wavelength with a first radiant intensity in the blue wavelength region (400 nm to 480 nm), a peak wavelength with a second radiant intensity in the green wavelength region (480 nm to 590 nm), which is less than the first radiant intensity, and a peak wavelength with a third radiant intensity in the red wavelength region (590 nm to 750 nm), which is less than the second radiant intensity.

Here, the first radiant intensity may be in the range of 1.8 times to 2.2 times the second radiant intensity or the third radiant intensity.

In addition, the radiant flux in the blue region may be in the range of 30% to 50% of the total radiant flux. Further, the radiant flux in the green region may be in the range of 30% to 40% of the total radiant flux. Further, the radiant flux in the red region may be in the range of 10% to 30% of the total radiant flux. Furthermore, the radiant flux in the red region may be less than the radiant flux in the green region. A higher radiant flux in the green region allows the light emitting apparatus to achieve a higher luminous flux by emitting a greater quantity of light in the color gamut with higher visual sensitivity. Thereby having the effect of making a person perceive greater brightness at the same energy. To implement this, the light emitting device 20 may use light emitting diodes 21 that emit light with different peak wavelengths. Alternatively, this can be implemented using a wavelength converter 22 that includes a light emitting diode 21 and a phosphor with a narrow peak wavelength.

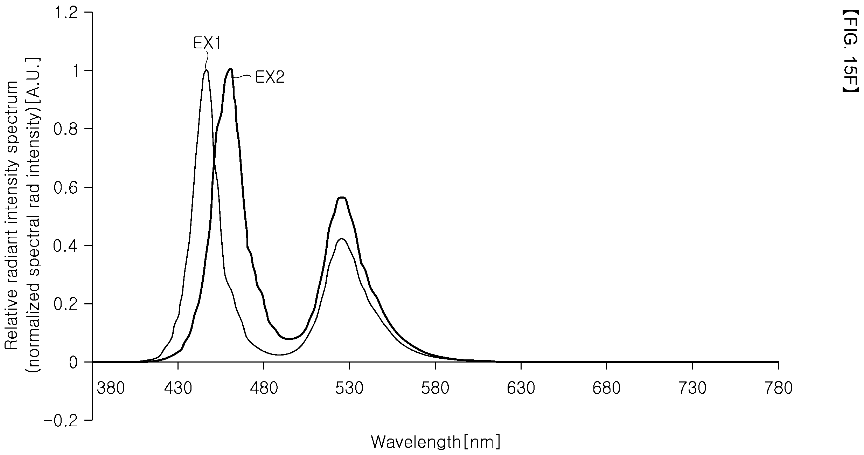

Next, FIG. 15F shows two examples Ex1, Ex2 of the relative radiant intensity spectrum of light emitted from the blue light emitting diode 21 and the green light emitting diode 21 or the light emitting diode 21 having a plurality of peaks, when light emitted from the light emitting device 20 has peak wavelengths of blue and green. In FIG. 15F, the relative radiant intensity spectrum may have a peak wavelength with a first radiant intensity in the blue wavelength region (400 nm to 480 nm) and a peak wavelength with a second radiant intensity in the green wavelength region (480 nm to 590 nm), which is less than the first radiant intensity. Here, the relative radiant intensity spectrum may not have a peak wavelength in the red wavelength region (590 nm to 750 nm).

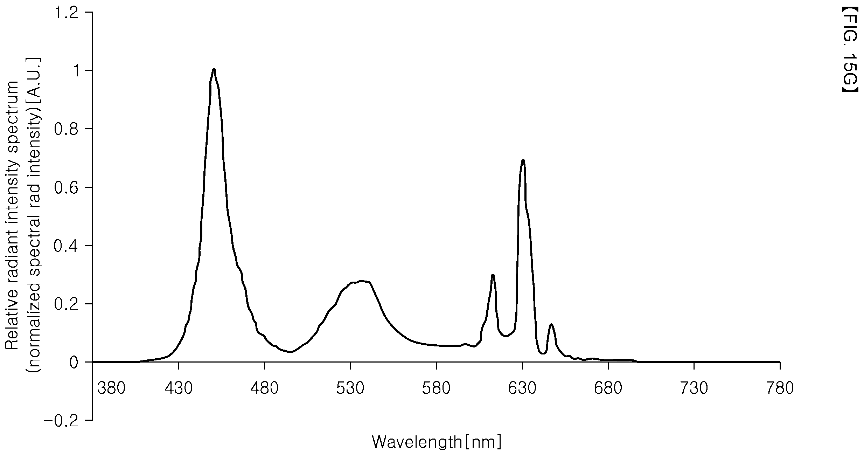

FIG. 15G shows a relative radiant intensity spectrum when the light emitting device 20 includes two blue light emitting diodes 21 and two green light emitting diodes 21 or a light emitting diode having a plurality of peaks and the wavelength converter 22 further includes the red wavelength conversion material (that is, blue light + green light + red wavelength conversion material). The red wavelength conversion material is a substance having a narrow spectrum of excitation wavelengths and may include KSF as a fluoride compound. Here, the wavelength converter 22 may further include a wavelength conversion material having a peak in the green region. And it may compensate for luminous intensity in the green region, which is insufficient when the light emitting diode 21 is used alone.

Referring to FIG. 15G, the relative radiant intensity spectrum of the emitted light may have a peak wavelength with a first radiant intensity in the blue wavelength region (400 nm to 480 nm), a peak wavelength (for example, 540 nm) having a second radiant intensity in the green wavelength region (480 nm to 590 nm), which is less than the first radiant intensity, and a peak wavelength in the red wavelength region (590 nm to 750 nm). Further, the red wavelength region (590 nm to 750 nm) may have a narrower full width at half maximum than the other wavelength regions and may have a plurality of peaks. The third radiant intensity in the red wavelength region (590 nm to 750 nm) has the highest value and may be greater than the second radiant intensity and less than the first radiant intensity. That is, the radiant intensity at the peak wavelength in the red wavelength region may be less than the first radiant intensity and greater than the second radiant intensity, without being limited thereto. For example, the third radiant intensity may be greater than the first radiant intensity and the second radiant intensity. When the full width at half maximum in the red region is narrow or the radiant intensity in the red region is high, the light emitting apparatus can realize a clearer red color, thereby improving the color reproduction rate. Here, the first radiant intensity may be greater than the second radiant intensity and the third radiant intensity. In addition, the third radiant intensity may be greater than the second radiant intensity.

The first radiant flux in the blue region may be in the range of 30% to 50% of the total radiant flux. In addition, the second radiant flux in the green region may be in the range of 30% to 40% of the total radiant flux. Further, the third radiant flux in the red region may be in the range of 10% to 30% of the total radiant flux. Furthermore, the third radiant flux may be less than the second radiant flux. A higher radiant flux in the green region allows the light emitting apparatus to achieve a higher luminous flux by emitting a greater quantity of light in the color gamut with higher visual sensitivity. Thereby it may have the effect of making a person perceive greater brightness at the same energy.

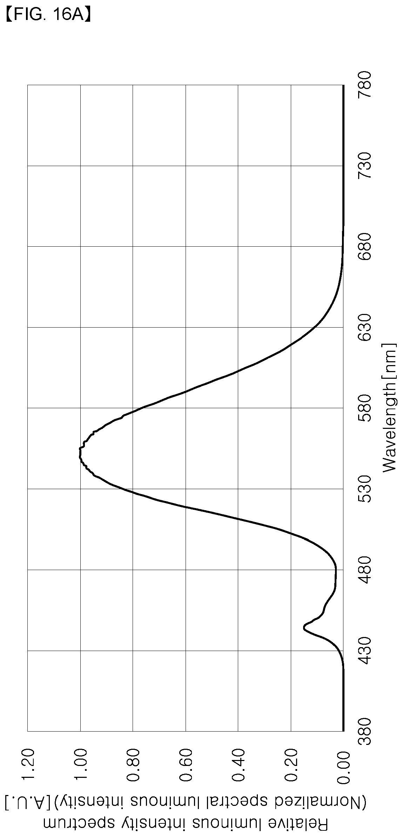

Next, FIG. 16A to FIG. 16E show relative luminous intensity spectra (normalized luminous intensity) derived by considering the spectral luminous efficacy curve ($Y(\lambda)$) for the relative radiant intensity spectra of FIG. 15A to FIG. 15E, respectively.

First, FIG. 16A shows a relative luminous intensity spectrum with respect to FIG. 15A, in which the relative luminous intensity spectrum of the emitted light may have a peak wavelength having a first luminous intensity in the blue wavelength region (400 nm to 480 nm) and a peak wavelength having a second luminous intensity in the green wavelength region (480 nm to 590 nm), which is greater than the first luminous intensity. Here, the second luminous intensity may be in the range of 4 times to 10 times the first luminous intensity. The relative luminous intensity spectrum may not exhibit a peak wavelength in the red wavelength region (590 nm to 750 nm). The blue peak wavelength may realize colors in the blue region, thereby increasing the color reproduction rate in the blue region.

Here, the second luminous intensity may be the maximum luminous intensity. The luminous flux in the blue region may be in the range of 1% to 10% of the total luminous flux. In addition, the luminous flux in the green region may be in the range of 60% to 90% of the total luminous flux. Further, the luminous flux in the red region may be in the range of 10% to 30% of the total luminous flux. Furthermore, the luminous flux in the red region may be less than the luminous flux in the green region. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy.

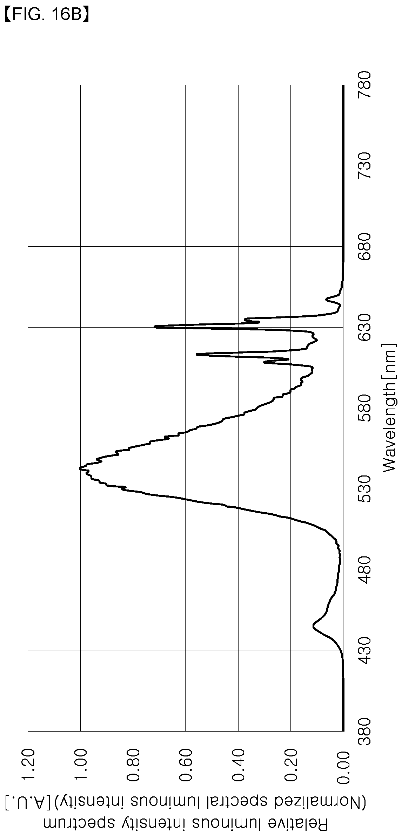

Next, FIG. 16B shows a relative luminous intensity spectrum with respect to FIG. 15B, in which the relative luminous intensity spectrum of the emitted light may have a peak wavelength having a first luminous intensity in the blue wavelength region (400 nm to 480 nm), a peak wavelength having a second luminous intensity in the green wavelength region (480 nm to 590 nm), which is greater than the first luminous intensity, and a peak wavelength in the red wavelength region (590 nm to 750 nm). Here, a plurality of peaks may be formed in the red wavelength region (590 nm to 750 nm) and may have the third luminous intensity in the red region, which is the highest value.

In the red wavelength region (590 nm to 750 nm), the luminous intensity of the peak wavelength may be greater than the first luminous intensity and less than the second luminous intensity. Higher luminous intensity in the red region than the luminous intensity in the blue region may increase the color reproduction rate in the red gamut, thereby realizing a clear red color.

The luminous flux in the blue region may be in the range of 1% to 10% of the total luminous flux. In addition, the luminous flux in the green region may be in the range of 60% to 90% of the total luminous flux. Further, the luminous flux in the red region may be in the range of 15% to 30% of the total luminous flux. Furthermore, the luminous flux in the red region may be greater than the luminous flux in the blue region. A higher luminous flux in the red region may provide a clearer red color through improvement in color reproduction rate in the red gamut.

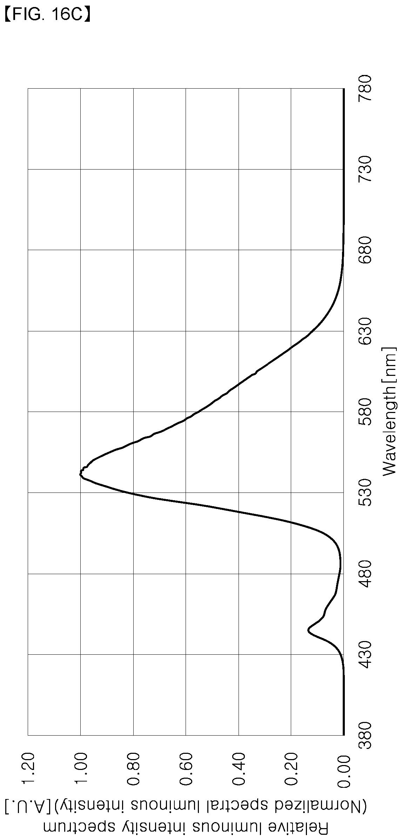

Next, FIG. 16C shows a relative luminous intensity spectrum with respect to FIG. 15C, in which the relative luminous intensity spectrum of the emitted light may have a peak wavelength having a first luminous intensity in the blue wavelength region (400 nm to 480 nm) and a peak wavelength having a second luminous intensity in the green wavelength region (480 nm to 590 nm), which is greater than the first luminous intensity.

Here, the second luminous intensity may be in the range of 1.8 times to 2.2 times the first luminous intensity and may be the maximum luminous intensity.

The light in the green wavelength region and the red wavelength region may be light converted by the wavelength converter 22. The spectra in the green wavelength region and the red wavelength region may have narrower full widths at half maximum than the spectrum of FIG. 16A. The narrower full widths at half maximum of the spectrum make it easier to realize more accurate and purer colors. In addition, the luminous flux spectrum may have a gentler slope in the red region than in the green region, which avoids overlapping between the spectra in the blue region and in the red region, thereby improving brightness of a color having passed through the color filter.

The luminous flux in the blue region may be in the range of 1% to 10% of the total luminous flux. In addition, the luminous flux in the green region may be in the range of 60% to 90% of the total luminous flux. Further, the luminous flux in the red region may be in the range of 10% to 30% of the total luminous flux. Further, the luminous flux in the red region may be less than the luminous flux in the green region. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy. The luminous flux in the red region, which is higher than in the blue region, increases the color reproduction rate of red, thereby providing a clear red color.

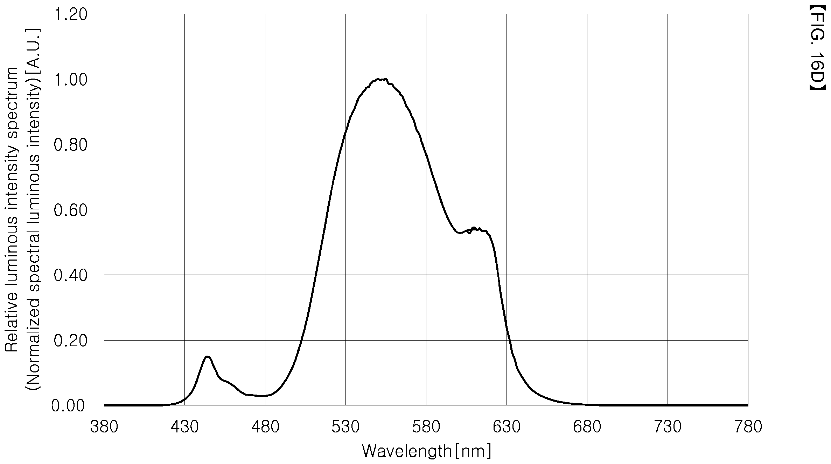

Next, FIG. 16D shows a relative luminous intensity spectrum with respect to FIG. 15D, in which the relative luminous flux spectrum may have a peak wavelength having a first luminous intensity in the blue wavelength region (400 nm to 480 nm) and a peak wavelength having a second luminous intensity in the green wavelength region (480 nm to 590 nm), which is greater than the first luminous intensity. The relative luminous flux spectrum may have a third luminous intensity in the red wavelength region, which is greater than the first luminous intensity and less than the second luminous intensity. Here, the second luminous intensity may be in the range of 4 times to 7 times the first luminous intensity and may be the maximum luminous intensity. High luminous intensity in the green region can make a person perceive bright even at the same luminous intensity.

The third luminous intensity may be in the range of 2.2 times to 5.5 times the first luminous intensity. High red luminous intensity can realize a clear red color. The second luminous intensity may be in the range of 1.5 times to 2 times the third luminous intensity. High luminous intensity in the green region can make a person perceive bright.

The luminous flux in the blue region may be in the range of 2% to 10% of the total luminous flux. In addition, the luminous flux in the green region may be in the range of 60% to 90% of the total luminous flux. Further, the luminous flux in the red region may be in the range of 10% to 30% of the total luminous flux. Furthermore, the luminous flux in the red region may be less than the luminous flux in the green region. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy.

The relative luminous intensity spectrum of the light emitting apparatus 100 may have a first valley between the first luminous intensity and the second luminous intensity. The first valley may have a luminous intensity between 470 nm and 490 nm and less than 10% of the second luminous intensity. The first valley may divide a color in the blue region and a color in the green region, thereby improving the color reproduction rates of blue and green.

The relative luminous intensity spectrum of the light emitting apparatus 100 may also have a second valley between the second luminous intensity and the third luminous intensity. The second valley may have a luminous intensity of less than 60% of the second luminous intensity. Accordingly, the light emitting apparatus 100 can increase the color reproduction rates of green and red. To implement such a structure, the light emitting device 20 may include a light emitting diode 21 with a half-width of 20 nm or less. Alternatively, the light emitting device 20 may include a wavelength converter 22 that contains a phosphor with an excitation spectrum having a half-width of 30 nm or less.

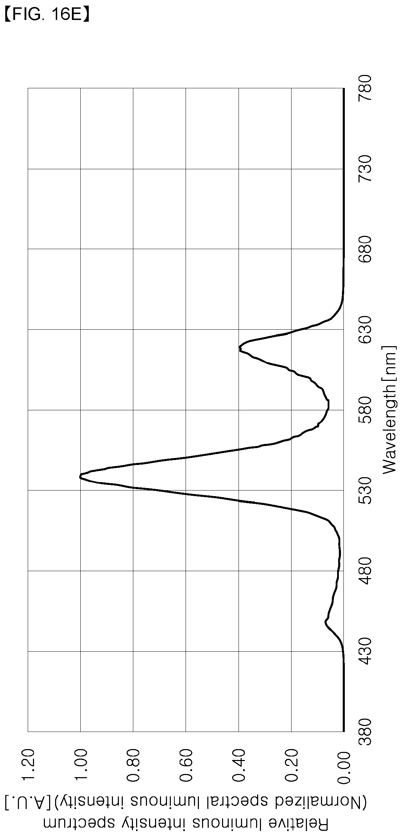

Finally, FIG. 16E shows a relative luminous intensity spectrum with respect to FIG. 15E, in which the relative luminous intensity spectrum may have a peak wavelength having a first luminous intensity in the blue wavelength region (400 nm to 480 nm) and a peak wavelength having a second luminous intensity in the green wavelength region (590 nm to 750 nm), which is greater than the first luminous intensity, a peak wavelength having a third luminous intensity in the red wavelength region (590 nm to 750 nm). The third luminous intensity is greater than the first luminous intensity and less than the second luminous intensity.

The second luminous intensity is the maximum luminous intensity and may be in the range of 8 times to 10 times the first luminous intensity and in the range of 2 times to 3 times the third luminous intensity. Higher luminous intensity in the green region makes a person perceive bright even at the same luminous intensity.

In addition, the relative luminous intensity spectrum of the light emitting apparatus may have two distinct valleys within a spectral region in each wavelength region. The regions separated by the valleys can realize clear colors through improvement of color purity.

In addition, each spectrum may have a full width at half maximum greater than or equal to 10 nm and less than 35 nm. The full width at half maximum in the blue region may be in the range of 10 nm to 20 nm. The full width at half maximum in the green region may be in the range of 20 nm to 35 nm. The full width at half maximum in the red region may be in the range of 20 nm to 30 nm. A narrow full width at half maximum in each region may increase the color reproduction rate through improvement in color purity of the light emitting apparatus.

The luminous flux in the blue region may be in the range of 0.5% to 10% of the total luminous flux. In addition, the luminous flux in the green region may be in the range of 60% to 90% of the total luminous flux. Further, the luminous flux in the red region may be in the range of 10% to 30% of the total luminous flux. Furthermore, the luminous flux in the red region may be less than the luminous flux in the green region. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy.

The relative luminous intensity spectrum of the light emitting apparatus 100 may have a first valley between the first luminous intensity and the second luminous intensity. The first valley may have a luminous intensity between 470 nm and 490 nm and less than 10% of the second luminous intensity. The first valley may divide a color in the blue region and a color in the green region, thereby improving the color reproduction rates of blue and green. The relative luminous intensity spectrum of the light emitting apparatus 100 may also have a second valley between the second luminous intensity and the third luminous intensity. The second valley may have a luminous intensity of less than 20% of the second luminous intensity. Alternatively, the second valley may have a luminous intensity of less than 50% of the second luminous intensity. Accordingly, the light emitting apparatus 100 may increase the color reproduction rates of green and red.

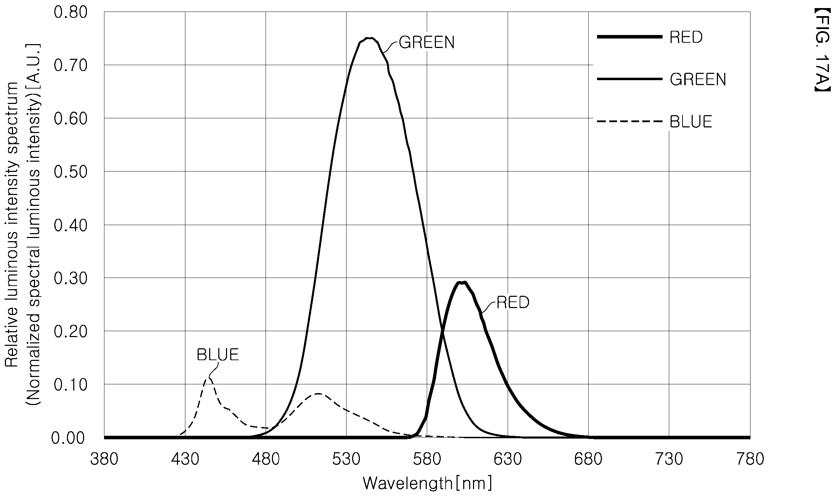

Next, FIGS. 17A to 17E show relative luminous intensity spectra derived by considering the spectral luminous efficacy curve ($Y(\lambda)$) for light emitted from the light emitting device 20 having the relative radiant intensity spectra of FIGS. 15A to 15E, respectively, when the light emitted from the light emitting device 20 passes through the color filter 150.

Referring to FIG. 17A to FIG. 17E, a filtered relative luminous intensity spectrum of light having passed through the color filter 150 may represent a blue filtered spectrum having a peak wavelength having a first filtered luminous intensity in the blue wavelength region (400 nm to 480 nm), a green filtered spectrum having a peak wavelength having a second filtered luminous intensity in the green wavelength region (590 nm to 750 nm), which is greater than the first filtered luminous intensity, and a red filtered spectrum having a peak wavelength having a third filtered luminous intensity in the red wavelength region (590 nm to 750 nm). The first filtered luminous intensity may be the lowest intensity, the second filtered luminous intensity may be the highest intensity, and the third filtered luminous intensity may have an intensity value between the first filtered luminous intensity and the second filtered luminous intensity.

In addition, the light having passed through the color filter may also exhibit a spectral shape having a first filtered luminous intensity in the blue wavelength region (400 nm to 480 nm), a second filtered luminous intensity in the green wavelength region (590 to 750 nm), which is greater than the first filtered luminous intensity, and a third filtered luminous intensity in the red wavelength region (590 nm to 750 nm), which is greater than the first filtered luminous intensity and less than the second filtered luminous intensity. Due to a difference in filtered luminous intensity in each color gamut, the display apparatus can realize clearer colors.

The difference in filtered luminous intensity in each color gamut also reduces mixing of light in each region, thereby providing a high color reproduction rate. The filtered luminous intensity in each region can be reduced by 3% to 30% after passing through the color filter, as compared to the luminous intensity before passing through the color filter.

Here, the blue filtered spectrum may have a sub-peak in the green wavelength region, which can increase luminosity of light having passed through the blue filter, thereby making the light appear brighter.

The light emitting apparatus 100 according to the disclosed technology is configured to have a relative radiant intensity/luminous intensity spectrum in each wavelength region, thereby securing high color reproduction through improvement in color clarity and color reproduction rate, and a display apparatus including such a light emitting apparatus 100 can be realized. In this way, the light emitting apparatus 100 according to the disclosed technology can implement a different luminous flux in each wavelength region, thereby realizing high color purity and efficient luminosity.

FIG. 17A shows a filtered relative luminous intensity spectrum of the color filter-transmitted light of FIG. 15A and FIG. 16A, in which the first filtered luminous intensity may be in the range of 5% to 20% of the second filtered luminous intensity and may be reduced by 10% to 30% from the first luminous intensity before filter transmission of the light.

In addition, the second filtered luminous intensity may be in the range of 1.8 times to 2.2 times the first filtered luminous intensity, may be the maximum luminous intensity, and may be reduced by 20% to 30% from the second luminous intensity before filter transmission of the light.

Further, the third filtered luminous intensity in the red region may be reduced by 20% to 30% from the third luminous intensity before transmission through the red filter. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy.

In addition, the area of the first filtered luminous intensity, that is, the area of the luminous intensity spectrum in the blue wavelength region (luminous intensity spectrum with respect to the luminous flux $L_{f\_b}(x_\lambda)$ in the blue wavelength region), may be greater than or equal to 10% and less than 20% of the area of the total luminous intensity spectrum (luminous intensity spectrum with respect to the total luminous flux $L_{f\_out}(x_\lambda)$). The area of the second filtered luminous intensity, that is, the area of the luminous intensity spectrum in the green wavelength region (luminous intensity spectrum with respect to the luminous flux $L_{f\_g}(x_\lambda)$ in the green wavelength region), may be greater than or equal to 60% and less than 80% of the area of the total luminous intensity spectrum. The area of the third filtered luminous intensity, that is, the area of the luminous intensity spectrum in the red wavelength region (luminous intensity spectrum with respect to the luminous flux $L_{f\_r}(x_\lambda)$ in the red wavelength region), may be greater than or equal to 5% and less than 10% of the area of the total luminous intensity spectrum. Relative to the total luminous intensity, the luminous intensity in the green region may have the highest value, followed by the luminous intensity in the blue region and then the luminous intensity in the red region. For example, the ratio of the luminous intensity in the blue wavelength region, the luminous intensity in the green wavelength region, and the luminous intensity in the red wavelength region to the total luminous intensity may be 1:7:2.

In addition, a first filtered peak luminous intensity of the first filtered luminous intensity may be greater than or equal to 10% and less than 15% of a second filtered peak luminous intensity of the second filtered peak luminous intensity. Further, a third filtered peak luminous intensity, which is a peak luminous intensity of the third filtered luminous intensity, may be greater than or equal to 30% and less than 50% of the second filtered peak luminous intensity. The third filtered peak luminous intensity may be greater than or equal to twice and less than 3 times the first filtered peak luminous intensity, thereby enabling improvement in color reproduction rate in a clear red region through the high red peak luminous intensity.

Further, the first filtered luminous intensity may have a full width at half maximum of 10 nm to 20 nm, the second filtered luminous intensity may have a full width at half maximum of 60 nm to 70 nm, and the third filtered luminous intensity may have a full width at half maximum of 30 nm to 40 nm. That is, the full width at half maximum in the green region may be greater than the full width at half maximum in the blue region and the area of the green area with high visual sensitivity may be enlarged, thereby causing a person to perceive greater brightness. In addition, the first to third filtered luminous intensities may not overlap each other in the region of the full width at half maximum from each peak, thereby realizing clear colors through clear division of the color gamut bands.

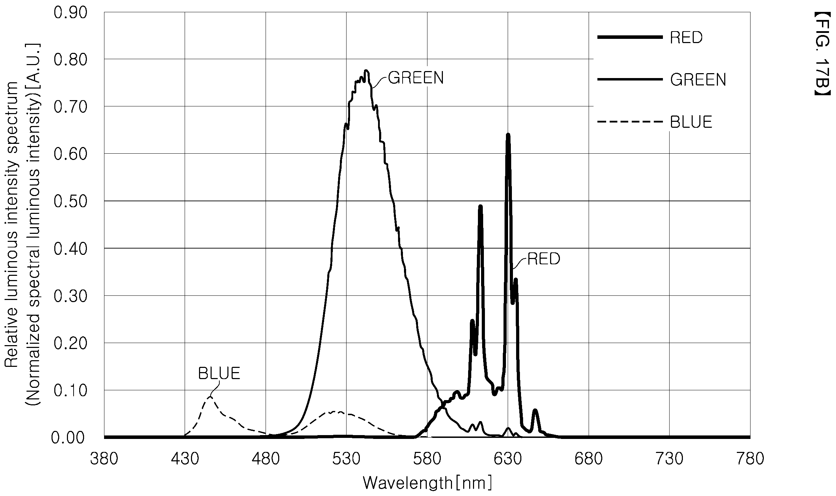

FIG. 17B shows a filtered relative luminous intensity spectrum of the color filter-transmitted light of FIG. 15B and FIG. 16B, in which the first filtered luminous intensity may be in the range of 5% to 20% of the second filtered luminous intensity and may be reduced by 10% to 30% from the first luminous intensity before filter transmission of the light. In addition, the second filtered luminous intensity may be in the range of 1.8 times to 2.2 times the first filtered luminous intensity, may be the maximum luminous intensity, and may be reduced by 20% to 30% from the second luminous intensity before filter transmission of the light. Further, the third filtered luminous intensity in the red region may be reduced by 20% to 30% from the third luminous intensity before transmission through the red filter.

The red filtered spectrum may include a plurality of narrow full width at half maximum spectra. The plurality of narrow full width at half maximum red spectra can increase color purity of red, thereby improving a red color reproduction rate of the light emitting apparatus. In addition, the green filtered spectrum may have a narrow full width at half maximum of 40 nm or less, thereby improving a green color reproduction rate.

In addition, the area of the first filtered luminous intensity, that is, the area of the luminous intensity spectrum in the blue wavelength region (luminous intensity spectrum with respect to the luminous flux $L_{f\_b}(x_\lambda)$ in the blue wavelength region), may be greater than or equal to 5% and less than 15% of the area of the total luminous intensity spectrum (luminous intensity spectrum with respect to the total luminous flux $L_{f\_out}(x_\lambda)$). The area of the second filtered luminous intensity, that is, the area of the luminous intensity spectrum in the green wavelength region (luminous intensity spectrum with respect to the luminous flux $L_{f\_g}(x_\lambda)$ in the green wavelength region), may be greater than or equal to 50% and less than 80% of the area of the total luminous intensity spectrum. The area of the third filtered luminous intensity, that is, the area of the luminous intensity spectrum in the red wavelength region (luminous intensity spectrum with respect to the luminous flux $L_{f\_r}(x_\lambda)$ in the red wavelength region), may be greater than or equal to 10% and less than 30% of the area of the total luminous intensity spectrum. Relative to the total luminous intensity, the luminous intensity in the green region may have the highest value, followed by the luminous intensity in the blue region and then the luminous intensity in the red region. For example, the ratio of the luminous intensity in the blue wavelength region, the luminous intensity in the green wavelength region, and the luminous intensity in the red wavelength region to the total luminous intensity may be 1:6:3.

In addition, a first filtered peak luminous intensity, which is the maximum luminous intensity of the first filtered luminous intensity, may be greater than or equal to 5% and less than 10% of a second filtered peak luminous intensity, which is the maximum luminous intensity of the second filtered luminous intensity. Further, a third filtered peak luminous intensity, which is a peak luminous intensity of the third filtered luminous intensity, may be greater than or equal to 80% and less than 120% of the second filtered peak luminous intensity. And the peak luminous intensity in the red region may be similar to the peak luminous intensity in the green region. Further, the third filtered peak luminous intensity may be greater than or equal to 6 times and less than 8 times the first filtered peak luminous intensity. Thereby, it may enable an improvement in color reproduction rate in the clear red region through narrow and high red peak luminous intensity.

In addition, the first filtered luminous intensity may have a full width at half maximum of 15 nm to 25 nm. The second filtered luminous intensity may have a full width at half maximum of 35 nm to 45 nm. And the full width at half maximum of the third filtered luminous intensity may have a plurality of peaks between 2 nm to 10 nm. The peaks with narrow full widths at half maximum may represent accurate colors in each color gamut, thereby increasing the color reproduction rate of the light emitting apparatus 100. Particularly it may realize a clear red color due to the narrow full widths at half maximum in the red region.

In addition, the first to third filtered luminous intensities may not overlap each other in a region of the full width at half maximum from each peak, thereby realizing clear colors through clear division of the color gamut.

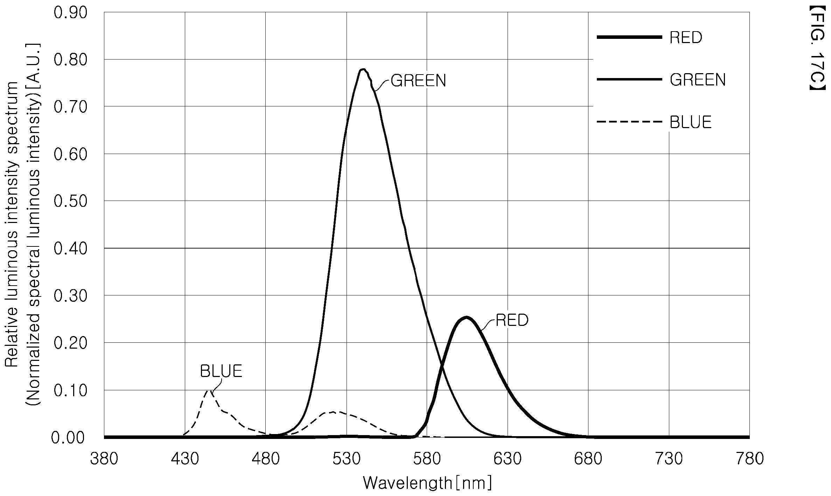

FIG. 17C shows a filtered relative luminous intensity spectrum of the color filter-transmitted light of FIG. 15C and FIG. 16C, in which the first filtered luminous intensity may be in the range of 5% to 20% of the second filtered luminous intensity and may be reduced by 10% to 30% from the first luminous intensity before filter transmission of the light. In addition, the second filtered luminous intensity may be in the range of 1.8 times to 2.2 times the first filtered luminous intensity, may be the maximum luminous intensity. And the second filtered luminous intensity may be reduced by 20% to 30% from the second luminous intensity before filter transmission of the light. Further, the third filtered luminous intensity in the red region may be reduced by 20% to 30% from the third luminous intensity before transmission through the red filter. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy.

In addition, the area of the first filtered luminous intensity, that is, the area of the luminous intensity spectrum in the blue wavelength region (luminous intensity spectrum with respect to the luminous flux $L_{f\_b}(x_\lambda)$ in the blue wavelength region), may be greater than or equal to 5% and less than 15% of the area of the total luminous intensity spectrum (luminous intensity spectrum with respect to the total luminous flux $L_{f\_out}(x_\lambda)$). The area of the second filtered luminous intensity, that is, the area of the luminous intensity spectrum in the green wavelength region (luminous intensity spectrum with respect to the luminous flux $L_{f\_g}(x_\lambda)$ in the green wavelength region), may be greater than or equal to 60% and less than 80% of the area of the total luminous intensity spectrum. The area of the third filtered luminous intensity, that is, the area of the luminous intensity spectrum in the red wavelength region (luminous intensity spectrum with respect to the luminous flux $L_{f\_r}(x_\lambda)$ in the red wavelength region), may be greater than or equal to 20% and less than 35% of the area of the total luminous intensity spectrum. Relative to the total luminous intensity, the luminous intensity in the green region may have the highest value, followed by the luminous intensity in the blue region and then the luminous intensity in the red region. For example, the ratio of the luminous intensity in the blue wavelength region, the luminous intensity in the green wavelength region, and the luminous intensity in the red wavelength region to the total luminous intensity may be 1:7:2.

Further, a first filtered peak luminous intensity of the first filtered luminous intensity may be greater than or equal to 5% and less than 15% of a second filtered peak luminous intensity of the second filtered luminous intensity. Further, a third filtered peak luminous intensity, which is a peak luminous intensity of the third filtered luminous intensity, may be greater than or equal to 30% and less than 40% of the second filtered peak luminous intensity. The third filtered peak luminous intensity may be greater than or equal to twice and less than 3 times the first filtered peak luminous intensity, thereby enabling improvement in brightness through increase in green peak luminous intensity instead of a relatively low blue peak luminous intensity. In addition, the third filtered peak luminous intensity can increase the color reproduction rate in a clear red region through increase in red peak luminous intensity.

Further, the first filtered luminous intensity may have a full width at half maximum of 15 nm to 25 nm, the second filtered luminous intensity may have a full width at half maximum of 35 nm to 45 nm, and the third filtered luminous intensity may have a full width at half maximum of 30 nm to 40 nm, in which the relatively wide full width at half maximum in the red region can increase the luminous intensity in the red region corresponding to the area of the red region, thereby realizing a bright red color.

In addition, the first to third filtered luminous intensities may not overlap each other in a region of the full width at half maximum from each peak. Thereby it may realize clear colors through clear division of the color gamut.

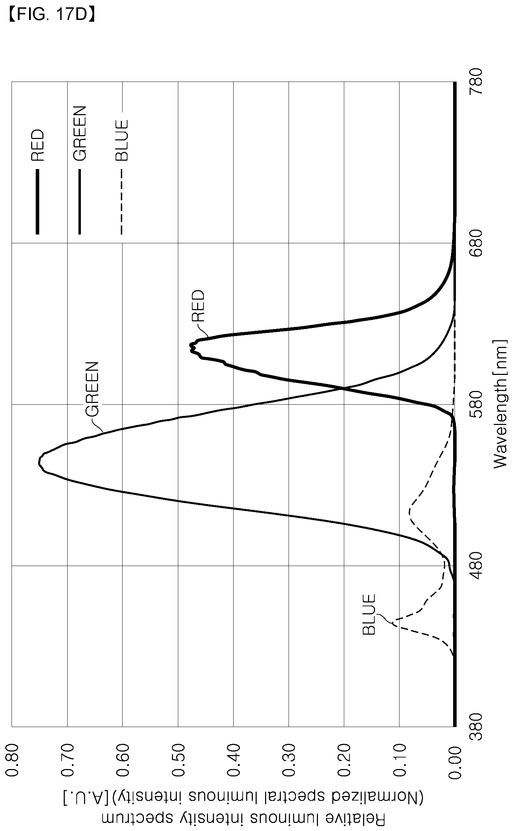

FIG. 17D shows a filtered relative luminous intensity spectrum of the color filter-transmitted light of FIG. 15D and FIG. 16D, in which the first filtered luminous intensity may be in the range of 5% to 20% of the second filtered luminous intensity and may be reduced by 10% and 30% from the first luminous intensity before filter transmission of the light. In addition, the second filtered luminous intensity may be in the range of 1.8 times to 2.2 times the first filtered luminous intensity, may be the maximum luminous intensity, and may be reduced by 20% to 30% from the second luminous intensity before filter transmission of the light. Further, the third filtered luminous intensity in the red region may be reduced by 20% to 30% from the third luminous intensity before the red filter transmission. Here, the red region may have a narrower full width at half maximum than 40 nm. By reducing the full width at half maximum in the red region, a clear red color can be obtained in the red region, thereby realizing a high reproduction rate in the red region. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy.

In addition, the area of the first filtered luminous intensity, that is, the area of the luminous intensity spectrum in the blue wavelength region (luminous intensity spectrum with respect to the luminous flux $L_{f\_b}(x_\lambda)$ in the blue wavelength region), may be greater than or equal to 5% and less than 10% of the area of the total luminous intensity spectrum (luminous intensity spectrum with respect to the total luminous flux $L_{f\_out}(x_\lambda)$). The area of the second filtered luminous intensity, that is, the area of the luminous intensity spectrum in the green wavelength region (luminous intensity spectrum with respect to the luminous flux $L_{f\_g}(x_\lambda)$ in the green wavelength region), may be greater than or equal to 60% and less than 80% of the area of the total luminous intensity spectrum. The area of the third filtered luminous intensity, that is, the area of the luminous intensity spectrum in the red wavelength region (luminous intensity spectrum with respect to the luminous flux $L_{f\_r}(x_\lambda)$ in the red wavelength region), may be greater than or equal to 15% and less than 25% of the area of the total luminous intensity spectrum. Relative to the total luminous intensity, the luminous intensity in the green region may have the highest value, followed by the luminous intensity in the blue region and then the luminous intensity in the red region. For example, the ratio of the luminous intensity in the blue wavelength region, the luminous intensity in the green wavelength region, and the luminous intensity in the red wavelength region to the total luminous intensity may be 1:7:2.

Further, a first filtered peak luminous intensity of the first filtered luminous intensity may be greater than or equal to 10% and less than 15% of a second filtered peak luminous intensity of the second filtered luminous intensity. Further, a third filtered peak luminous intensity, which is a peak luminous intensity of the third filtered luminous intensity, may be greater than or equal to 35% and less than 50% of the second filtered peak luminous intensity. The third filtered peak luminous intensity may be greater than or equal to twice and less than 3 times the first filtered peak luminous intensity, and can increase the color reproduction rate in a clear red region through increase in red peak luminous intensity.

Further, the first filtered luminous intensity may have a full width at half maximum of 15 nm to 25 nm. The second filtered luminous intensity may have a full width at half maximum of 60 nm to 70 nm. And the third filtered luminous intensity may have a full width at half maximum of 30 nm to 40 nm, in which the relatively wide full width at half maximum in the green region may increase the area of the green region with high visual sensitivity. thereby, it may cause a person to perceive greater brightness.

In addition, the first to third filtered luminous intensities may not overlap each other in a region of the full width at half maximum from each peak, thereby realizing clear colors through clear division of the color gamut.

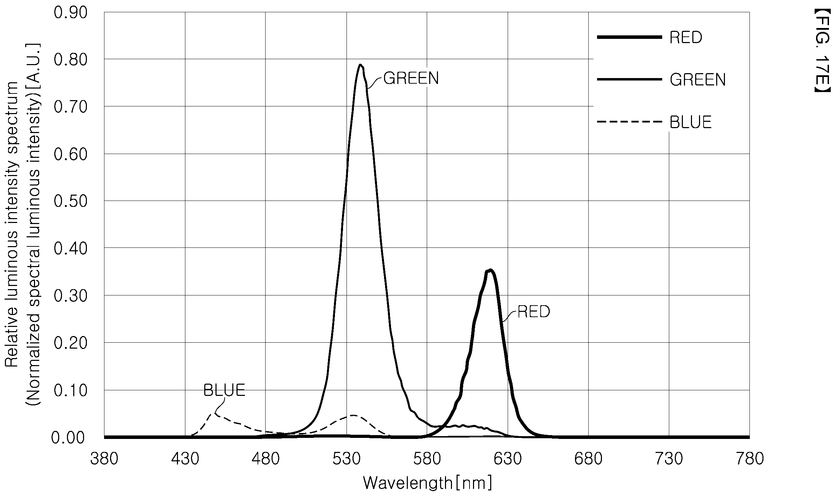

FIG. 17E shows a filter relative luminous intensity spectrum of the color filter-transmitted light of FIG. 15E and FIG. 16E, in which the first filtered luminous intensity may be in the range of 5% to 20% of the second filtered luminous intensity. And it may be reduced by 10% to 30% from the first luminous intensity before filter transmission of the light. In addition, the second filtered luminous intensity may be in the range of 1.8 times to 2.2 times the first filtered luminous intensity. the second filtered luminous may be the maximum luminous intensity. And the second filtered luminous may be reduced by 20% to 30% from the second luminous intensity before filter transmission of the light. Further, the third filtered luminous intensity in the red region may be reduced by 20% to 30% from the third luminous intensity before transmission through the red filter.

Here, the green filtered spectrum may have a narrow full width at half maximum than 30 nm. By reducing the full width at half maximum in the green region, high color purity can be obtained in the green region, thereby improving the color reproduction rate of the green region. The red region may also have a narrower half width at half maximum than 30 nm. By reducing the full width at half maximum in the red region, a clear red color can be obtained in the red region, thereby realizing a high reproduction rate in the red region. A higher luminous flux in the green region allows the light emitting apparatus to achieve a higher luminous flux by emitting a greater quantity of light in the color gamut with higher visual sensitivity. Thereby it may have the effect of making a person perceive greater brightness at the same energy. To implement this, the light emitting device 20 may include a light emitting diode 21 or a phosphor in the wavelength converter 22 with a narrow half-width of 30 nm or less in the blue, green, and red regions.

In addition, the area of the first filtered luminous intensity, that is, the area of the luminous intensity spectrum in the blue wavelength region (luminous intensity spectrum with respect to the luminous flux $L_{f\_b}(x_\lambda)$ in the blue wavelength region), may be greater than or equal to 5% and less than 10% of the area of the total luminous intensity spectrum (luminous intensity spectrum with respect to the total luminous flux $L_{f\_out}(x_\lambda)$). The area of the second filtered luminous intensity, that is, the area of the luminous intensity spectrum in the green wavelength region (luminous intensity spectrum with respect to the luminous flux $L_{f\_g}(x_\lambda)$ in the green wavelength region), may be greater than or equal to 60% and less than 80% of the area of the total luminous intensity spectrum. The area of the third filtered luminous intensity, that is, the area of the luminous intensity spectrum in the red wavelength region (luminous intensity spectrum with respect to the luminous flux $L_{f\_r}(x_\lambda)$ in the red wavelength region), may be greater than or equal to 20% and less than 30% of the area of the total luminous intensity spectrum. Relative to the total luminous intensity, the luminous intensity in the green region may have the highest value, followed by the luminous intensity in the blue region and then the luminous intensity in the red region. For example, the ratio of the luminous intensity in the blue wavelength region, the luminous intensity in the green wavelength region, and the luminous intensity in the red wavelength region to the total luminous intensity may be 0.8:6.7:2.5. To implement this, the peak transmittance value of the color filter 150 in the light emitting device 100 may be the highest in the red region and the lowest in the blue region.

Further, a first filtered peak luminous intensity of the first filtered luminous intensity may be greater than or equal to 5% and less than 10% of a second filtered peak luminous intensity of the second filtered luminous intensity. Further, a third filtered peak luminous intensity, which is a peak luminous intensity of the third filtered luminous intensity, may be greater than or equal to 40% and less than 50% of the second filtered peak luminous intensity. The third filtered peak luminous intensity may be greater than or equal to 5 times and less than 6 times the first filtered peak luminous intensity. The high peak luminosities allow accurate representation of colors in each gamut, thereby increasing the color reproduction rate of the light emitting apparatus 100.

Further, the first filtered luminous intensity may have a full width at half maximum of 15 nm to 25 nm. The second filtered luminous intensity may have a full width at half maximum of 20 nm to 30 nm. And the third filtered luminous intensity may have a full width at half maximum of 20 nm to 30 nm, in which the peaks with narrow full widths at half maximum enable accurate representation of colors in each gamut, thereby increasing the color reproduction rate of the light emitting apparatus 100.

In addition, the first to third filtered luminous intensities may not overlap each other not only in a region of the full width at half maximum from each peak, but also in a region of $\pm 30\%$ or less from each peak. Thereby it may realize vivid, rich, clear colors.

Although some exemplary embodiments have been described herein with reference to the accompanying drawings, it should be understood that various modifications and changes can be made by those skilled in the art or by a person having ordinary knowledge in the art without departing from the spirit and scope of the disclosed technology, as defined by the claims and equivalents thereto.

Therefore, the scope of the disclosed technology should be defined only by the appended claims and equivalents thereto rather than by the detailed description of the disclosed technology.

Further possible examples are provided in the following paragraphs.

Example 1: A light emitting apparatus comprising:

A light emitting apparatus comprising: a substrate; and at least one light emitting device disposed on the substrate and configured to emit light,
wherein, when a total luminous flux of light emitted from the light emitting device is denoted by $L_{out}(x_\lambda)$ and a luminous flux in a blue wavelength region is denoted by $L_b(x_\lambda)$, $L_{out}(x_\lambda)$ and $L_b(x_\lambda)$ are defined by the following equations:

$$L_{out}(x_\lambda) = 683.002 \cdot \int_{400}^{750} \overline{y}(\lambda)\Phi_{e,\lambda}(\lambda)d\lambda,$$

$$L_b(x_\lambda) = 683.002 \cdot \int_{400}^{480} \overline{y}(\lambda)\Phi_{e,\lambda}(\lambda)d\lambda,$$

where y($\lambda$) is a spectral luminous efficacy curve depending on wavelengths ($\lambda$) and $\Phi_{e,\lambda}(\lambda)$ is a power density spectrum depending on the wavelengths, and
wherein the luminous flux in the blue wavelength region is in the range of 0.01 times to 0.1 times the total luminous flux.

Example 2: The light emitting apparatus according to Example 1, wherein when a luminous flux in a green wavelength region is denoted by $L_g(x_\lambda)$, $L_g(x_\lambda)$ is defined by the following equation:

$$L_g(x_\lambda) = 683.002 \cdot \int_{480}^{590} \overline{y}(\lambda)\Phi_{e,\lambda}(\lambda)d\lambda,$$

the luminous flux in the green wavelength region being in the range of 0.7 times to 0.89 times the total luminous flux.
Example 3: The light emitting apparatus according to Example 2, wherein the luminous flux in the green wavelength region is in the range of 20 times to 90 times the luminous flux in the blue wavelength region.
Example 4: The light emitting apparatus according to Example 1, wherein, when a luminous flux in a red wavelength region is denoted by $L_r(x_\lambda)$, $L_r(x_\lambda)$ is defined by the following equation:

$$L_r(x_\lambda) = 683.002 \cdot \int_{590}^{750} \overline{y}(\lambda)\Phi_{e,\lambda}(\lambda)d\lambda,$$

the luminous flux in the red wavelength region being in the range of 0.15 times to 0.3 times the total luminous flux.
Example 5: The light emitting apparatus according to Example 4, wherein the luminous flux in the red wavelength region is in the range of 3 times to 30 times the luminous flux in the blue wavelength region.
Example 6: The light emitting apparatus according to Example 1, wherein the light emitted from the light emitting device has a peak wavelength with a first radiant intensity in the blue wavelength region and a peak wavelength with a second radiant intensity in a green wavelength region, the second radiant intensity being less than the first radiant intensity.
Example 7: The light emitting apparatus according to Example 6, wherein the light emitted from the light emitting device has a plurality of peak wavelengths in a red wavelength region, and
wherein one of the plurality of peak wavelengths is a peak wavelength with a third radiant intensity less than the first radiant intensity and greater than the second radiant intensity.
Example 8: A light emitting apparatus comprising: a substrate; and at least one light emitting device disposed on the substrate and configured to emit light,

wherein the light emitting device comprises a circuit board and at least one light emitting diode mounted on the circuit board;
light emitted from the light emitting device has a peak wavelength with a first radiant intensity in a blue wavelength region and a peak wavelength with a second radiant intensity in a green wavelength region, the second radiant intensity being less than the first radiant intensity, and
the first radiant intensity is greater than or equal to 4 times the second radiant intensity.

Example 9: The light emitting apparatus according to Example 8, wherein a first radiant flux in the blue wavelength region is in the range of 30% to 50% of the total radiant flux,

a second radiant flux in the green wavelength region is in the range of 30% to 40% of the total radiant flux, and
a third radiant flux in a red wavelength region is in the range of 10% to 30% of the total radiant flux.

Example 10: The light emitting apparatus according to Example 8, wherein the light emitting device further includes a wavelength converter,
the wavelength converter including at least one of green, yellow, or red wavelength conversion materials.
Example 11: The light emitting apparatus according to Example 10, wherein the wavelength converter comprises a fluoride compound as the red wavelength conversion material.

Example 12: The light emitting apparatus according to Example 10, wherein light emitted from the light emitting device has a peak wavelength with a third radiant intensity in a red wavelength region, the third radiant intensity being less than the first radiant intensity and greater than the second radiant intensity.

Example 13: The light emitting apparatus according to Example 12, wherein the light emitted from the light emitting device has a plurality of intensity peaks in the red wavelength region and the third radiant intensity is the highest radiant intensity among the plurality of intensity peaks.

Example 14: The light emitting apparatus according to Example 10, wherein the light emitted from the light emitting device has a peak wavelength with a third radiant intensity in a red wavelength region, the third radiant intensity being less than the first radiant intensity and the second radiant intensity

Example 15: The light emitting apparatus according to Example 12, wherein the light emitting device comprises at least one blue light emitting diode and at least one green light emitting diode, and the wavelength converter includes a red wavelength conversion material.

Example 16: A light emitting apparatus comprising: a substrate; and at least one light emitting device disposed on the substrate and configured to emit light,

wherein, when a total luminous flux of light emitted from the light emitting device is denoted by $L_{out}(x_\lambda)$ and a luminous flux in a blue wavelength region is denoted by $L_b(x_\lambda)$,
$L_{out}(x_\lambda)$ and $L_b(x_\lambda)$ are defined by the following equations:

$$L_{out}(x_\lambda) = 683.002 \cdot \int_{400}^{750} \overline{y}(\lambda)\Phi_{e,\lambda}(\lambda)d\lambda,$$

$$L_b(x_\lambda) = 683.002 \cdot \int_{400}^{480} \overline{y}(\lambda)\Phi_{e,\lambda}(\lambda)d\lambda,$$

where $y(\lambda)$ is a spectral luminous efficacy curve depending on wavelengths $(\lambda)$ and $\Phi_{e,\lambda}(\lambda)$ is a power density spectrum depending on the wavelengths, and
wherein the luminous flux in the blue wavelength region is in the range of 0.01 times to 0.1 times the total luminous flux and a color reproduction rate is greater than or equal to 85%.

Example 17: The light emitting apparatus according to Example 16, wherein a gamut ratio is greater than or equal to 85%.

Example 18: The light emitting apparatus according to Example 16, further comprising:

a color filter through which light emitted from the light emitting device passes,
wherein red color coordinates (Xr, Yr) of the light are shifted to a shorter wavelength side after the light passes through the color filter.

Example 19: The light emitting apparatus according to Example 18, wherein green color coordinates (Xg, Yg) and blue color coordinates (Xb, Yb) of the light are shifted to a longer wavelength side after the light passes through the color filter.

Example 20: The light emitting apparatus according to Example 18, wherein a luminous intensity of the light is reduced by 3% to 30% after the light passes through the color filter.

[List of Reference Numerals]

| | | | |
|---|---|---|---|
| 10: | substrate | 20: | Light emitting device |
| 21, 21 a, 21b, 21 c: | Light emitting diode | 22: | Wavelength converter |
| 23: | Side wall | 24: | Circuit board |
| 24a: | Upper interconnection | 24b: | Lower interconnection |
| 24c: | Through-interconnection | | |
| 30: | Lens | | |
| 40: | Back light panel | 100: | Light emitting apparatus |
| 110: | Back light unit | 120: | First polarizing plate |
| 130: | TFT layer | | |
| 140: | Liquid crystal layer | | |

(continued)

| 150: | Color filter |
| 160: | Second polarizing plate |
| 170: | Quantum dot film |

**Claims**

1. A light emitting apparatus comprising: a substrate; and at least one light emitting device disposed on the substrate and configured to emit light,

   wherein, when a total luminous flux of light emitted from the light emitting device is denoted by $L_{out}(x_\lambda)$ and a luminous flux in a blue wavelength region is denoted by $L_b(x_\lambda)$,
   $L_{out}(x_\lambda)$ and $L_b(x_\lambda)$ are defined by the following equations:

$$L_{out}(x_\lambda) = 683.002 \cdot \int_{400}^{750} \overline{y}(\lambda)\Phi_{e,\lambda}(\lambda)d\lambda,$$

$$L_b(x_\lambda) = 683.002 \cdot \int_{400}^{480} \overline{y}(\lambda)\Phi_{e,\lambda}(\lambda)d\lambda,$$

   where $y(\lambda)$ is a spectral luminous efficacy curve depending on wavelengths ($\lambda$) and $\Phi_{e,\lambda}(\lambda)$ is a power density spectrum depending on the wavelengths, and
   wherein the luminous flux in the blue wavelength region is in the range of 0.01 times to 0.1 times the total luminous flux.

2. The light emitting apparatus according to claim 1, wherein, when a luminous flux in a green wavelength region is denoted by $L_g(x_\lambda)$, $L_g(x_\lambda)$ is defined by the following equation:

$$L_g(x_\lambda) = 683.002 \cdot \int_{480}^{590} \overline{y}(\lambda)\Phi_{e,\lambda}(\lambda)d\lambda,$$

   the luminous flux in the green wavelength region being in the range of 0.7 times to 0.89 times the total luminous flux.

3. The light emitting apparatus according to claim 2, wherein the luminous flux in the green wavelength region is in the range of 20 times to 90 times the luminous flux in the blue wavelength region.

4. The light emitting apparatus according to claim 1, wherein, when a luminous flux in a red wavelength region is denoted by $L_r(x_\lambda)$, $L_r(x_\lambda)$ is defined by the following equation:

$$L_r(x_\lambda) = 683.002 \cdot \int_{590}^{750} \overline{y}(\lambda)\Phi_{e,\lambda}(\lambda)d\lambda,$$

   the luminous flux in the red wavelength region being in the range of 0.15 times to 0.3 times the total luminous flux.

5. The light emitting apparatus according to claim 4, wherein the luminous flux in the red wavelength region is in the range of 3 times to 30 times the luminous flux in the blue wavelength region.

6. The light emitting apparatus according to claim 1, wherein the light emitted from the light emitting device has a peak wavelength with a first radiant intensity in the blue wavelength region and a peak wavelength with a second radiant intensity in a green wavelength region, the second radiant intensity being less than the first radiant intensity.

7. The light emitting apparatus according to claim 6,

   wherein the light emitted from the light emitting device has a plurality of peak wavelengths in a red wavelength region, and

wherein one of the plurality of peak wavelengths is a peak wavelength with a third radiant intensity less than the first radiant intensity and greater than the second radiant intensity.

8. The light emitting apparatus according to claim 1, wherein the light emitting device further includes a wavelength converter,
the wavelength converter including at least one of green, yellow, or red wavelength conversion materials.

9. The light emitting apparatus according to claim 8, wherein the wavelength converter comprises a fluoride compound as the red wavelength conversion material.

10. The light emitting apparatus according to claim 8, wherein light emitted from the light emitting device has a peak wavelength with a third radiant intensity in a red wavelength region, the third radiant intensity being less than the first radiant intensity and greater than the second radiant intensity.

11. The light emitting apparatus according to claim 9, wherein the light emitted from the light emitting device has a plurality of intensity peaks in the red wavelength region and the third radiant intensity is the highest radiant intensity among the plurality of intensity peaks.

12. The light emitting apparatus according to claim 8, wherein the light emitted from the light emitting device has a peak wavelength with a third radiant intensity in a red wavelength region, the third radiant intensity being less than the first radiant intensity and the second radiant intensity.

13. The light emitting apparatus according to claim 1, further comprising:

a color filter through which light emitted from the light emitting device passes,
wherein red color coordinates (Xr, Yr) of the light are shifted to a shorter wavelength side after the light passes through the color filter.

14. The light emitting apparatus according to claim 13, wherein green color coordinates (Xg, Yg) and blue color coordinates (Xb, Yb) of the light are shifted to a longer wavelength side after the light passes through the color filter.

15. The light emitting apparatus according to claim 13, wherein a luminous intensity of the light is reduced by 3% to 30% after the light passes through the color filter.

【FIG. 1A】

100

| R | G | B |

160
150
140
130
120
110

【FIG. 1B】

100

| R | G | B |

160
150
140
130
120
170
110

【FIG. 2】

【FIG. 3】

【FIG. 4】

20

21    22

23

24a
24
24b

24c

【FIG. 5】

20

21    22

23

24a
24
24b

24c

EP 4 586 772 A1

【FIG. 6】

33

【FIG. 7】

【FIG. 8】

【FIG. 9】

【FIG. 10】

【FIG. 11】

【FIG. 12】

【FIG. 13A】

【FIG. 13B】

【FIG. 14A】

【FIG. 14B】

【FIG. 14C】

【FIG. 15A】

【FIG. 15B】

EP 4 586 772 A1

[FIG. 15C]

【FIG. 15D】

【FIG. 15E】

【FIG. 15F】

【FIG. 15G】

【FIG. 16A】

【FIG. 16B】

【FIG. 16C】

【FIG. 16D】

【FIG. 16E】

【FIG. 17A】

【FIG. 17B】

【FIG. 17C】

[FIG. 17D]

EP 4 586 772 A1

【FIG. 17E】

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/317362 A1 (HUANG SHIH-CHANG [TW] ET AL) 17 October 2019 (2019-10-17) * paragraphs [0020] - [0054]; figures 1-9 * | 1-15 | INV. H10H29/14 H10H29/851 H10H29/85 |
| X | CN 113 113 527 A (AU OPTRONICS CORP) 13 July 2021 (2021-07-13) * paragraphs [0050] - [0076]; figures 1-9 * | 1-15 | |
| X | WO 2023/188921 A1 (NICHIA CORP [JP]) 5 October 2023 (2023-10-05) * paragraphs [0001] - [0114] * | 1-15 | |
| X | US 2022/398987 A1 (WYATT DAVID [US]) 15 December 2022 (2022-12-15) * the whole document * * figures 46,47 * | 1-15 | |

**TECHNICAL FIELDS SEARCHED (IPC)**

H10H

The present search report has been drawn up for all claims

| Place of search | Date of completion of the search | Examiner |
|---|---|---|
| The Hague | 9 May 2025 | Simeonov, Dobri |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
............................................................................................
& : member of the same patent family, corresponding
    document

EPO FORM 1503 03.82 (P04C01)

# EP 4 586 772 A1

## ANNEX TO THE EUROPEAN SEARCH REPORT
## ON EUROPEAN PATENT APPLICATION NO.

EP 25 15 0623

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2025

| Patent document cited in search report | Publication date | Patent family member(s) | Publication date |
|---|---|---|---|
| US 2019317362 A1 | 17-10-2019 | CN 110389473 A | 29-10-2019 |
| | | CN 114637140 A | 17-06-2022 |
| | | CN 114637141 A | 17-06-2022 |
| | | EP 3557317 A1 | 23-10-2019 |
| | | JP 7129821 B2 | 02-09-2022 |
| | | JP 2019184990 A | 24-10-2019 |
| | | US 2019317362 A1 | 17-10-2019 |
| CN 113113527 A | 13-07-2021 | CN 113113527 A | 13-07-2021 |
| | | TW 202221943 A | 01-06-2022 |
| WO 2023188921 A1 | 05-10-2023 | CN 118985051 A | 19-11-2024 |
| | | DE 112023001711 T5 | 23-01-2025 |
| | | WO 2023188921 A1 | 05-10-2023 |
| US 2022398987 A1 | 15-12-2022 | US 11971616 B1 | 30-04-2024 |
| | | US 2021097943 A1 | 01-04-2021 |
| | | US 2022398987 A1 | 15-12-2022 |
| | | US 2024274095 A1 | 15-08-2024 |
| | | US 2024282274 A1 | 22-08-2024 |
| | | WO 2020210740 A1 | 15-10-2020 |

EPO FORM P0459

For more details about this annex : see Official Journal of the European Patent Office, No. 12/82

63